(19) Europäisches Patentamt
European Patent Office
Office européen des brevets

(11) EP 1 698 645 A1

(12) # EUROPEAN PATENT APPLICATION
published in accordance with Art. 158(3) EPC

(43) Date of publication:
**06.09.2006 Bulletin 2006/36**

(21) Application number: **04808040.2**

(22) Date of filing: **22.12.2004**

(51) Int Cl.:
***C08F 212/14*** *(2006.01)* ***G03F 7/039*** *(2006.01)*
***H01L 21/027*** *(2006.01)*

(86) International application number:
**PCT/JP2004/019689**

(87) International publication number:
**WO 2005/061566 (07.07.2005 Gazette 2005/27)**

(84) Designated Contracting States:
**AT BE BG CH CY CZ DE DK EE ES FI FR GB GR HU IE IS IT LI LT LU MC NL PL PT RO SE SI SK TR**

(30) Priority: **22.12.2003 JP 2003425707**
**10.06.2004 JP 2004172929**

(71) Applicant: **Lion Corporation**
**Tokyo 130-8644 (JP)**

(72) Inventors:
- **KANEKO, Yukihiro**
  **Sumida-ku, Tokyo 1308644 (JP)**
- **SUZUKI, Kaoru**
  **Sumida-ku, Tokyo 1308644 (JP)**
- **TAMURA, Minoru**
  **Sumida-ku, Tokyo 1308644 (JP)**
- **KUBO, Yoshiyasu**
  **Sumida-ku, Tokyo 1308644 (JP)**

(74) Representative: **Horner, Martin Grenville et al**
**Marks & Clerk Scotland**
**19 Royal Exchange Square**
**Glasgow G1 3AE**
**Scotland (GB)**

(54) **HYPERBRANCHED POLYMER, PROCESS FOR PRODUCING THE SAME AND RESIST COMPOSITION CONTAINING THE HYPERBRANCHED POLYMER**

(57) The present invention provides a hyperbranched polymer suitable as a polymer material for nanofabrication, in particular, photolithography. The hyperbranched polymer of the present invention is **characterized by** having a core portion prepared by a living radical polymerization of chloromethyl styrene or the like, and an acid decomposition group such as p-tert-butoxy styrene, which is linked to the core portion and present at the end of a molecule of the polymer.



Printed by Jouve, 75001 PARIS (FR)

## Description

### Technical Field

The present invention relates to a hyperbranched polymer that is useful as a polymer material for nanofabrication technologies, particularly photolithography, and a method for producing the hyperbranched polymer, and a resist composition containing the above-mentioned hyperbranched polymer as a base polymer for the resist material, capable of forming minute patterns thereon for fabrication of very large scale integrated circuits (VLSI).

### Background of the Invention

Photolithography, one of the up-and-coming nanopatterning technologies has recently pursued the higher resolution in line with the tendency to shorten the wavelengths of the light sources, and finally achieved high integration in the VLSI. In response to this, a base polymer for use in the resist composition having a chemical structure transparent to each light source has been developed. For example, there are proposed resist compositions containing a polymer having a basic skeleton of polyhydroxystyrene (PHS) for KrF excimer laser (with a wavelength of 248 nm); a polymer with an aliphatic structure for ArF excimer laser (with a wavelength of 193 nm); and a polymer where fluorine atom is introduced (to have a perfluoro structure) for F2 excimer laser (with a wavelength of 157 nm) (refer to WO00/17712).

However, when the above-mentioned polymers are applied to the formation of extremely minute patterns equivalent to or narrower than 50 nm that is supposed to become necessary in the future, the roughness on the side wall of the formed patterns, which is expressed by the line edge roughness has become an issue. It is pointed out in Franco Cerrina, Vac. Sci. Tech. B, 19, 62890 (2001) that it will be a challenge to control the surface smoothness of the resist on a nanometer level when the conventional resist materials predominantly comprising polymethyl methacrylate (PMMA) and polyhydroxystyrene (PHS) are exposed to electron beams or extreme ultraviolet (EUV) radiation to form patterns of 50 nm or narrower.

According to Toru Yamaguti, Jpn. J. Appl. Phys., 38, 7114 (1999), the roughness on the side wall of the pattern is considered to result from the presence of aggregates of polymer for constituting the resist, and therefore many reports on the technologies for preventing the molecular aggregation of the polymer are found.

For example, it is reported in Toru Yamaguti, Jpn. J. Appl. Phys., 38, 7114 (1999) that introduction of a crosslinking structure into the linear polymer is effective as means for improving the surface smoothness of the positive resist for use with the electron beams.

As one example of the branched polymers that can yield better line edge roughness than the linear molecules, Japanese Patent Unexamined Publication (JP Kokai) 2000-347412 discloses a polymer having a backbone of a straight-chain phenol derivative which is branched and concatenated. However, this polymer has not succeeded in the patterning of 50 nm or narrower.

A branched polyester having carboxyl group-containing phenol derivative is disclosed in Alexander R. Trimble, Proceedings of SPIE, 3999, 1198 (2000). However, this polymer has the drawback of poor adhesion to a substrate.

With respect to the higher degree of branching in a styrene derivative which plays a key role as a polymer in the lithography, it is reported in National Publication of the translated version (of PCT application) 2000-500516 and 2000-514479, and Krzysztof Matyjaszewski, Macromolecules 29, 1079 (1996) and M.J. Frecht, J. Poly. Sci., 36, 955 (1998) that living radical polymerization of chloromethyl styrene can make it possible to control the degree of branching and the weight average molecular weight.

At the present stage, however, there is no report on molecular designing for imparting the processability based on light exposure, which is required of the resist material, and it is thus desired to speed up the development.

### Disclosure of Invention

An object of the present invention is to provide a hyperbranched polymer having improved surface smoothness and alkali solubility, which hyperbranched polymer is applicable as a polymer material to nanofabrication technologies, particularly photolithography; a method for producing the hyperbranched polymer; and a resist composition containing the hyperbranched polymer.

The inventors of the present invention have intensively studied to solve the above-mentioned problems, and consequently made the following findings. Namely, it has been found that a hyperbranched polymer having a highly branched structure as a core portion and an acid decomposition group at the end of a molecule shows less intermolecular entanglement when compared with linear polymers and less swelling performance in solvents when compared with the molecular structures where the main chain is obtained by crosslinking, thereby preventing the formation of large molecular aggregates which would cause the surface roughness of the side wall of patterns. The hyperbranched polymer is usually spherical in shape. In the photolithography, when the acid decomposition group is present on the surface of the spherical

polymer, the decomposition reaction occurs at a light exposed portion by the action of an acid generated from a photoacid generator to produce a hydrophilic group. As a result, the hyperbranched polymer can exhibit a spherical micelle structure having a lot of hydrophilic groups on the spherical surface. Owing to the above-mentioned structure, the hyperbranched polymer can be efficiently dissolved in an alkaline aqueous solution to be removed by the alkaline solution, thereby leaving minute patterns. The hyperbranched polymer is thus considered to be preferably used as a base resin for the resist material.

The present invention has been accomplished based on the present inventors' findings mentioned above. Namely, the present invention provides a hyperbranched polymer having an acid decomposition group at the end of a molecule of the polymer.

Also, the present invention provides a hyperbranched polymer obtainable by subjecting a styrene derivative to a living radical polymerization reaction, wherein the hyperbranched polymer has an acid decomposition group at the end of a molecule of the polymer.

In the present invention, it is preferable that the core portion of the above-mentioned hyperbranched polymer be a homopolymer of a monomer represented by the following formula (1):

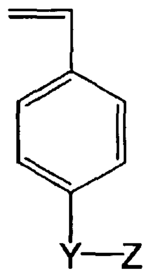

(1)

wherein Y is an alkylene group having 1 to 10 carbon atoms, which may include a hydroxyl group(s) or carboxyl group (s), and Z is a halogen atom; or a copolymer of from the monomer of formula (1) and at least one monomer selected from monomers of formulas (2) to (5):

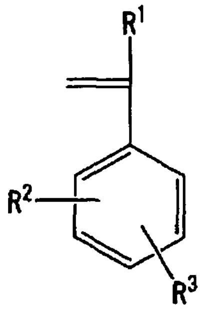

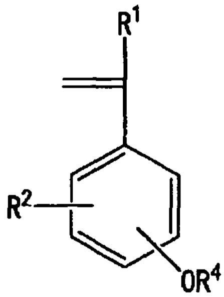

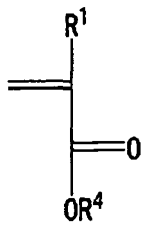

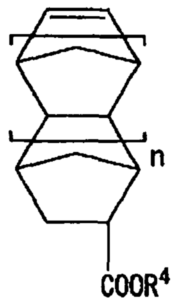

(2) (3) (4) (5)

wherein $R^1$ is hydrogen atom or an alkyl group having 1 to 3 carbon atoms;

$R^2$ and $R^3$, which may be the same or different, are each hydrogen atom, a straight-chain, branched or cyclic alkyl group having 1 to 30 carbon atoms or an aryl group having 6 to 30 carbon atoms;

$R^4$ is hydrogen atom, a straight-chain, branched or cyclic alkyl group having 1 to 40 carbon atoms, a trialkylsilyl group in which each alkyl moiety has 1 to 6 carbon atoms, an oxoalkyl group in which an alkyl moiety with 4 to 20 carbon atoms, or a group represented by the following formula (6) in which $R^5$ is a straight-chain, branched or cyclic alkyl group having 1 to 10 carbon atoms, and $R^6$ and $R^7$ are each independently hydrogen atom or a straight-chain, branched or cyclic alkyl group having 1 to 10 carbon atoms, or $R^6$ and $R^7$ may form a ring together when $R^6$ and $R^7$ are each a straight-chain, branched or cyclic alkyl group having 1 to 10 carbon atoms); and

n is an integer from 0 to 10.

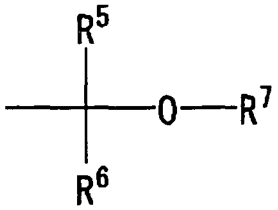

(6)

The present invention also provides a method for producing a hyperbranched polymer, comprising the step of carrying out a living radical polymerization of a monomer represented by the above-mentioned formula (1) alone or together with at least one monomer selected from the monomers of the above-mentioned formulas (2) to (5) to produce a polymer, and the step of reacting the resultant polymer with a compound containing an acid decomposition group to introduce the acid decomposition group into the polymer.

Further, the present invention provides a method for producing a hyperbranched polymer, comprising the step of synthesizing a hyperbranched polymer by a living radical polymerization reaction of a monomer represented by the following formula (1) and the step of introducing an acid decomposition group into the end of the hyperbranched polymer by reacting the synthesized hyperbranched polymer with a compound containing the acid decomposition group;

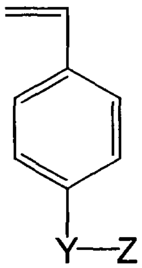

(1)

wherein Y is an alkylene group having 1 to 10 carbon atoms, which may include a hydroxyl group(s) or carboxyl group (s), and Z is a halogen atom.

The present invention also provides a resist composition containing the above-mentioned hyperbranched polymer.

The present invention can provide a hyperbranched polymer that can be free from the above-mentioned conventional problems and usable as a polymer material for nanofabrication technologies, particularly photolithography, and a resist composition containing the hyperbranched polymer which is suitable as a base polymer for the resist material conformable to the light sources of electron beams, deep ultraviolet (DUV) and extreme ultraviolet (EUV) required to produce nano-order surface smoothness and which is capable of forming minute patterns for fabrication of very large scale integrated circuits (VLSI).

The present invention can provide a base polymer for the resist material having improved surface smoothness and alkali solubility. Also, the present invention can provide a base polymer for the resist material which is excellent in terms of sensitivity, etching resistance and film-forming properties and is less contaminated with metal catalysts or the like.

Best Mode for Carrying out the Invention

(Hyperbranched Polymer and Production Method therefor)

The hyperbranched polymer of the present invention has a core portion with a highly branched structure and an acid decomposition group at the end portion.

The hyperbranched polymer of the present invention is obtainable by subjecting a styrene derivative to a living radical polymerization reaction, wherein an acid decomposition group is present at the end of the molecule thereof.

The hyperbranched polymer of the present invention can be obtained by a production method for hyperbranched polymer according to the present invention.

The production method for hyperbranched polymer according to the present invention includes the steps of

synthesizing the core portion and introducing an acid decomposition group, and other steps if necessary.

The production method for hyperbranched polymer according to the present invention will now be explained, through which the hyperbranched polymer of the present invention will be clarified in detail.

(Step of synthesizing core portion)

The monomer for constituting a core portion of the hyperbranched polymer of the present invention is not particularly limited so long as the monomer can be subjected to living radical polymerization, so that any monomer can be appropriately chosen according to the application. For example, the monomers represented by formulas (1) to (5) mentioned above are preferable.

The styrene derivative that can be used in the present invention is not particularly limited so long as the derivative can be subjected to a living radical polymerization, so that any styrene derivative can be appropriately chosen according to the application. For example, the styrene derivative represented by the structural formula (1) mentioned above is preferable.

More preferably, the core portion of the hyperbranched polymer of the present invention may be a homopolymer of the monomer of the above-mentioned formula (1) or a copolymer of the monomer of formula (1) and at least one monomer selected from the monomers of formulas (2) to (5).

Preferably, the molar ratio (%) of the constituent monomer represented by formula (1) may be 5 to 100%, preferably 20 to 100%, and more preferably 50 to 100% in the core portion of the hyperbranched polymer of the present invention.

In the above-mentioned formula (1), Y is a straight-chain, branched or cyclic alkylene group having 1 to 10 carbon atoms, preferably 1 to 8 carbon atoms, and more preferably 1 to 6 carbon atoms, which may include a hydroxyl group(s) or carboxyl group(s). Examples of such alkylene groups are methylene group, ethylene group, propylene group, isopropylene group, butylene group, isobutylene group, amylene group, hexylene group, cyclohexylene group and the like, which alkylene groups may be linked or to which alkylene groups -O-, -CO- or -COO- may be attached. Of those groups, alkylene groups having 1 to 8 carbon atoms, in particular, straight-chain alkylene groups having 1 to 8 carbon atoms are preferable, and methylene group, ethylene group, $-OCH_2-$ group and $-OCH_2CH_2-$ group are further preferable.

Z is a halogen atom such as fluorine, chlorine, bromine, iodine and the like. Of those halogen atoms, chlorine atom and bromine atom are preferable.

The monomer represented by the above formula (1) that can be used in the present invention includes, for example, chloromethyl styrene, bromomethyl styrene, p-(1-chloroethyl)styrene, bromo(4-vinylphenyl)phenylmethane, 1-bromo-1-(4-vinylphenyl)propan-2-one, 3-bromo-3-(4-vinylphenyl)propanol, and the like. Preferable are chloromethyl styrene, bromomethyl styrene and p-(1-chloroethyl)styrene.

In the above-mentioned formulas (2) to (5), $R^1$ is hydrogen atom or an alkyl group having 1 to 3 carbon atoms. Preferable are hydrogen atom and methyl group.

$R^2$ and $R^3$ are each hydrogen atom; a straight-chain, branched or cyclic alkyl group having 1 to 30 carbon atoms, preferably 1 to 20 carbon atoms, and more preferably 1 to 10 carbon atoms; or an aryl group having 6 to 30 carbon atoms, preferably 6 to 20 carbon atoms, and more preferably 6 to 10 carbon atoms, and $R^2$ and $R^3$ may be the same or different. Examples of the straight-chain, branched or cyclic alkyl group include methyl group, ethyl group, propyl group, isopropyl group, butyl group, isobutyl group, t-butyl group, cyclohexyl group and the like. Examples of the aryl group include phenyl group, 4-methylphenyl group, naphthyl group and the like. Preferable are hydrogen atom, methyl group, ethyl group and phenyl group.

$R^4$ is hydrogen atom; a straight-chain, branched or cyclic alkyl group having 1 to 40 carbon atoms, preferably 1 to 30 carbon atoms, and more preferably 1 to 20 carbon atoms; a trialkylsilyl group in which each alkyl moiety has 1 to 6 carbon atoms, preferably 1 to 4 carbon atoms; an oxoalkyl group in which an alkyl moiety with 4 to 20 carbon atoms, preferably 4 to 10 carbon atoms; or a group represented by the above-mentioned formula (6) in which $R^5$ is hydrogen atom, or a straight-chain, branched or cyclic alkyl group having 1 to 10 carbon atoms, preferably 1 to 8 carbon atoms, and more preferably 1 to 6 carbon atoms, and $R^6$ and $R^7$ are each independently hydrogen atom or a straight-chain, branched or cyclic alkyl group having 1 to 10 carbon atoms, preferably 1 to 8 carbon atoms, and more preferably 1 to 6 carbon atoms, or $R^6$ and $R^7$ may form a ring together.

In the above-mentioned definition of $R^4$, examples of the straight-chain, branched or cyclic alkyl group include methyl group, ethyl group, propyl group, isopropyl group, butyl group, isobutyl group, t-butyl group, cyclopentyl group, cyclohexyl group, cycloheptyl group, triethylcarbyl group, 1-ethylnorbonyl group, 1-methylcyclohexyl group, adamantyl group, 2-(2-methyl)adamantyl group, tert-amyl group and the like.

In the above-mentioned definition of $R^4$, the trialkylsilyl group includes trimethylsilyl group, triethylsilyl group, dimethyl-tert-butylsilyl group and the like, wherein each alkyl group has 1 to 6 carbon atoms. As the oxoalkyl group, 3-oxocyclohexyl group and the like can be employed.

Examples of the group represented by formula (6) include straight-chain or branched acetal groups such as

1-methoxyethyl group, 1-ethoxyethyl group, 1-n-propoxyethyl group, 1-isopropoxyethyl group, 1-n-butoxyethyl group, 1-isobutoxyethyl group, 1-sec-butoxyethyl group, 1-tert-butoxyethyl group, 1-tert-amyloxyethyl group, 1-ethoxy-n-propyl group, 1-cyclohexyloxyethyl group, methoxypropyl group, ethoxypropyl group, 1-methoxy-1-methyl-ethyl group, 1-ethoxy-1-methyl-ethyl group and the like; and cyclic acetal groups such as tetrahydrofuranyl group, tetrahydropyranyl group and the like. Particularly preferable are ethoxyethyl group, butoxyethyl group, ethoxypropyl group and tetrahydropyranyl group.

In the formula (5), n is an integer of 0 to 10, preferably 0 to 7, and more preferably 0 to 4.

Preferable monomers represented by formula (2) are those wherein $R^1$ is hydrogen atom or methyl group, and $R^2$ and $R^3$ are each independently hydrogen atom or a straight-chain or branched alkyl group having 1 to 6 carbon atoms. Specific examples of the monomer represented by formula (2) include styrene, α-methylstyrene, methylstyrene, dimethylstyrene, ethylstyrene, tert-butyl styrene, phenylstyrene and the like. Preferable are styrene, α-methylstyrene and methylstyrene.

Preferable monomers represented by formula (3) are those wherein $R^1$ is hydrogen atom or methyl group; $R^2$ is hydrogen atom or a straight-chain or branched alkyl group having 1 to 6 carbon atoms; and $R^4$ is hydrogen atom, a straight-chain, branched or cyclic alkyl group having 1 to 12 carbon atoms, a trialkylsilyl group in which each alkyl moiety has 1 to 6 carbon atoms, or a group represented by the above-mentioned formula (6) in which $R^5$ is a straight-chain, branched or cyclic alkyl group having 1 to 6 carbon atoms, and $R^6$ and $R^7$ are each independently hydrogen atom or a straight-chain, branched or cyclic alkyl group having 1 to 6 carbon atoms, or $R^6$ and $R^7$ may form a ring together. Specific examples of the monomer represented by formula (3) include hydroxystyrene, α-methyl hydroxystyrene, methoxystyrene, tert-butoxy styrene, cyclohexyloxystyrene, trimethylsiloxystyrene, 4-(1-methoxyethoxy)styrene, 4-(1-ethoxyethoxy)styrene, tetrahydropyranyloxystyrene, and the like. Particularly preferable are hydroxystyrene, methoxystyrene, tert-butoxy styrene, 4-(1-ethoxyethoxy)styrene and tetrahydropyranyloxystyrene.

Preferable monomers represented by formula (4) are those wherein $R^1$ is hydrogen atom or methyl group; and $R^4$ is hydrogen atom, a straight-chain, branched or cyclic alkyl group having 1 to 12 carbon atoms, or a group represented by the above-mentioned formula (6) in which $R^5$ is a straight-chain, branched or cyclic alkyl group having 1 to 6 carbon atoms, and $R^6$ and $R^7$ are each independently hydrogen atom or a straight-chain, branched or cyclic alkyl group having 1 to 6 carbon atoms, or $R^6$ and $R^7$ may form a ring together. Specific examples of the monomer represented by formula (4) include acrylic acid, methacrylic acid, methyl acrylate, methyl methacrylate, ethyl acrylate, butyl acrylate, tert-butyl acrylate, tert-butyl methacrylate, adamantyl acrylate, adamantyl methacrylate, 2-(2-methyl)adamantyl acrylate, 2-(2-methyl)adamantyl methacrylate and the like. Particularly preferable are acrylic acid, methacrylic acid, tert-butyl acrylate, tert-butyl methacrylate, 2-(2-methyl)adamantyl acrylate and 2-(2-methyl)adamantyl methacrylate.

Preferable monomers represented by formula (5) are those wherein $R^4$ is hydrogen atom or a straight-chain, branched or cyclic alkyl group having 1 to 12 carbon atoms, and n is 1 to 5. Specific examples of the monomer represented by formula (5) include the following compounds of formulas (a1) to (g1):

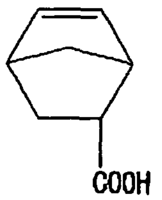
(a 1)

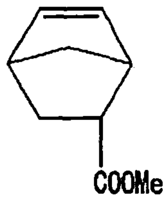
(b 1)

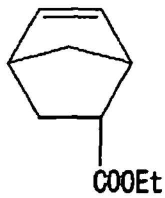
(c 1)

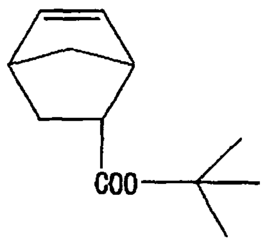
(d 1)

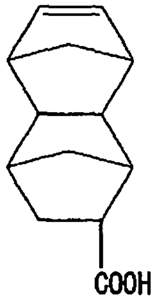

(e 1)

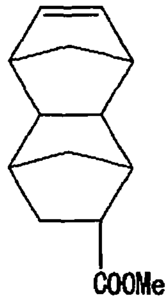

(f 1)

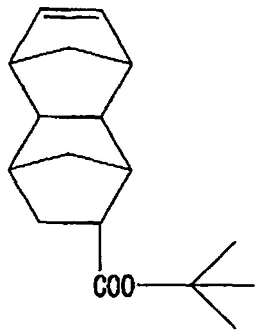

(g 1)

Among the above compounds, (a1), (d1), (e1) and (g1) are preferable.

When the core portion of the hyperbranched polymer of the present invention is a copolymer of the monomer of formula (1) and at least one monomer selected from the monomers of formulas (2) to (5), the above-mentioned formula (1) may be present in an amount of preferably 20 to 90 mol%, more preferably 50 to 80 mol%, with respect to the total monomers constituting the core portion. When the amount ratio of the monomers of formula (1) is within the above-mentioned range, the core portion can preferably form a spherical shape that can favorably inhibit the intermolecular entanglement.

The core portion of the hyperbranched polymer of the present invention can be synthesized by subjecting the monomer of formula (1) to a living radical polymerization, or subjecting the monomer of formula (1) and at least one monomer selected from the monomers of formulas (2) to (5) to a living radical polymerization reaction. To be more specific, raw material monomers are generally reacted at 0 to 200°C for 0.1 to 30 hours in a solvent such as chlorobenzene or the like to obtain the core portion of the hyperbranched polymer of the present invention.

The Y-Z linkage in the monomer of formula (1) undergoes reversible radical dissociation with the aid of a transition metal complex to suppress the bimolecular termination, whereby the living radical polymerization proceeds.

For instance, when chloromethyl styrene is used as a monomer of formula (1) and copper (I) bipyridyl complex is used as a catalyst, chlorine atom of the chloromethyl styrene will form an adduct with the copper (I) complex that is oxidized to copper (II), thereby obtaining an intermediate; while methylene radical occurs at the moiety where chlorine atom is removed (refer to Jean M.J. Frecht, J. Poly. Sci, 36, 955 (1998)).

The obtained radical intermediate reacts with the ethylenic double bond of another chloromethyl styrene to form a dimer of formula (9) shown below. At this moment, a primary carbon (1) and a secondary carbon (2) produced in the molecule have individually chloro group as a substituent, so that each chloro group will further react with the ethylenic double bond of another chloromethyl styrene. Polymerization with chloromethyl styrene takes place successively in this way.

In a tetramer represented by the following formula (10), primary carbons (1) and (2) and secondary carbons (3) and (4) have individually chloro group as a substituent, each of which will react with the ethylenic double bond of another chloromethyl styrene. By repeating the same reaction as mentioned above, a highly branched polymer is produced.

In the above reaction, the increase in amount of the copper complex as a catalyst will further improve the degree of branching. The catalyst may be used preferably in an amount of 0.1 to 60 mol%, more preferably 1 to 40 mol%, with respect to the total amount of the monomers of formula (1) for constituting the core portion. The use of the above-mentioned amount of catalyst will produce a core portion having a preferable degree of branching in the hyperbranched polymer, which will be described later.

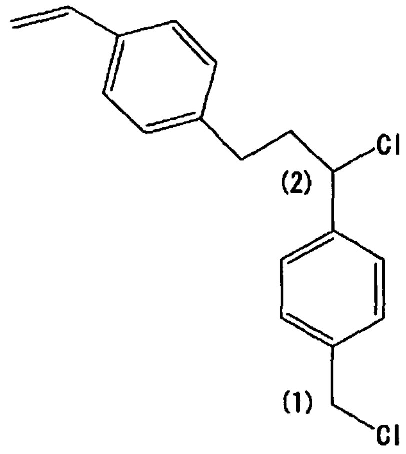

(9) Dimer

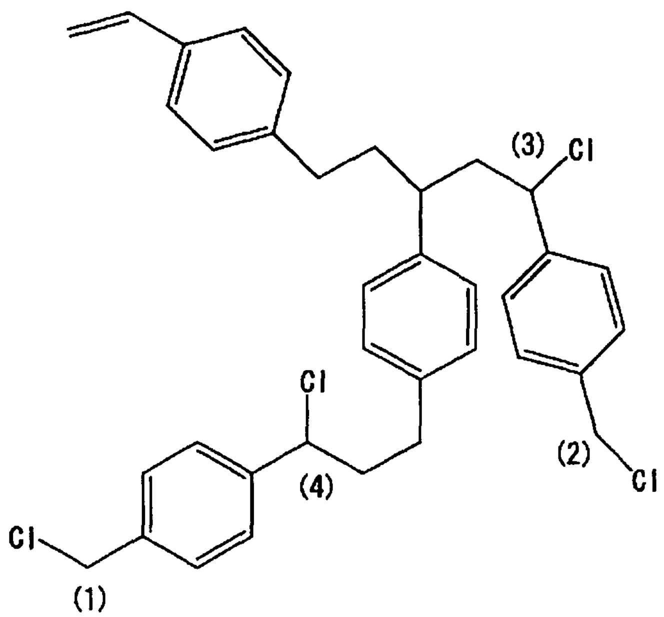

(10) Tetramer

The copolymer of the monomer of formula (1) and at least one monomer selected from the monomers of formulas (2) to (5) can be produced by a living radical polymerization using a transition metal catalyst in the same manner as in the homopolymerization of the monomer having formula (1).

Other monomers than those of formulas (1) to (5) can be used as the monomer for constituting the core portion of the hyperbranched polymer of the present invention, so long as the monomer includes a radical-polymerizable unsaturated bond.

The copolymerizable monomers that can be used in the present invention are as follows: for example, compounds having a radical-polymerizable unsaturated bond, selected from styrenes, acrylic esters and methacrylic esters other than the above, allyl compounds, vinyl ethers, vinyl esters and the like.

Specific examples of the styrenes include benzylstyrene, trifluoromethylstyrene, acetoxystyrene, chlorostyrene, dichlorostyrene, trichlorostyrene, tetrachlorostyrene, pentachlorostyrene, bromostyrene, dibromostyrene, iodostyrene,

fluorostyrene, trifluorostyrene, 2-bromo-4-trifluoromethylstyrene, 4-fluoro-3-trifluoromethylstyrene, vinyl naphthalene and the like.

Specific examples of the acrylic esters include chloroethyl acrylate, 2-hydroxyethyl acrylate, 2,2-dimethylhydroxypropyl acrylate, 5-hydroxypentyl acrylate, trimethylolpropane acrylate, glycidyl acrylate, benzyl acrylate, phenyl acrylate, naphthyl acrylate and the like.

Specific examples of the methacrylic esters include benzyl methacrylate, chlorobenzyl methacrylate, 2-hydroxyethyl methacrylate, 4-hydroxybutyl methacrylate, 5-hydroxypentyl methacrylate, 2,2-dimethyl-3-hydroxypropyl methacrylate, glycidyl methacrylate, phenyl methacrylate, naphthyl methacrylate and the like.

Specific examples of the allyl esters include allyl acetate, allyl caproate, allyl caprylate, allyl laurate, allyl palmitate, allyl stearate, allyl benzoate, allyl acetoacetate, allyl lactate, allyloxy ethanol and the like.

Specific examples of the vinyl ethers include hexylvinyl ether, octylvinyl ether, decylvinyl ether, ethylhexylvinyl ether, methoxyethylvinyl ether, ethoxyethylvinyl ether, chloroethylvinyl ether, 1-methyl-2,2-dimethylpropylvinyl ether, 2-ethylbutylvinyl ether, hydroxyethylvinyl ether, diethylene glycol vinyl ether, dimethylaminoethylvinyl ether, diethylaminoethylvinyl ether, butylaminoethylvinyl ether, benzylvinyl ether, tetrahydrofurfurylvinyl ether, vinylphenyl ether, vinyltolyl ether, vinylchlorophenyl ether, vinyl-2,4-dichlorophenyl ether, vinylnaphthyl ether, vinylanthranyl ether and the like.

Specific examples of the vinyl esters include vinyl butyrate, vinyl isobutyrate, vinyl trimethylacetate, vinyl diethylacetate, vinyl valeate, vinyl caproate, vinyl chloroacetate, vinyl dichloroacetate, vinyl methoxyacetate, vinyl butoxyacetate, vinyl phenylacetate, vinyl acetoacetate, vinyl lactate, vinyl-β-phenylbutyrate, vinyl cyclohexylcarboxylate and the like.

Of those monomers, styrenes are preferable, and in particular, benzylstyrene, chlorostyrene and vinyl naphthalene are preferable.

In the hyperbranched polymer of the present invention, preferably the molar ratio (%) of the monomers constituting the core portion may be 10 to 90%, preferably 20 to 80%, and more preferably 30 to 70%. When the molar ratio (%) of the monomers constituting the core portion is within the above-mentioned range, proper hydrophobic properties with respect to a developer solution can be preferably obtained, so that non-light exposed portions can be prevented from being dissolved.

When the monomers other than those represented by formulas (1) to (5) are used for constituting the core portion, the amount of the monomers having formulas (1) to (5) may be preferably 40 to 90 mol%, and more preferably 50 to 80 mol%, with respect to the total monomers constituting the core portion. The use of the monomers having formulas (1) to (5) in such an amount as mentioned above is desirable because the obtained core portion can be provided with the functions, i.e., adhesion to the substrate, increase of the glass transition temperature and so on, with the spherical shape of the core portion being maintained. The amount of the monomers having formulas (1) to (5) and that of other monomers in the core portion can be controlled by adjusting the initial feeds for polymerization depending upon the purpose.

(Step of introducing acid decomposition group)

In the hyperbranched polymer of the present invention, the acid decomposition group can be introduced into the end of the polymer by reacting the hyperbranched polymer core portion synthesized by the method stated above with a compound containing an acid decomposition group.

The acid decomposition group herein used means a group that is decomposed by the action of acid (preferably, a photoacid generator capable of generating acid when irradiated with light energy). It is preferable to use a group that can be converted into a hydrophilic group upon decomposition. As the above-mentioned acid decomposition group, preferably used is an acid decomposition group selected from the group consisting of those having the following formulas (I) to (IV) and (7):

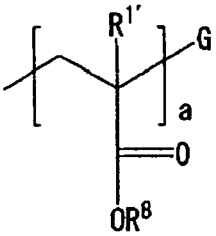
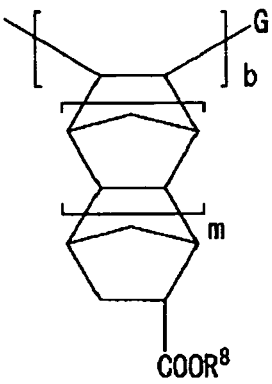
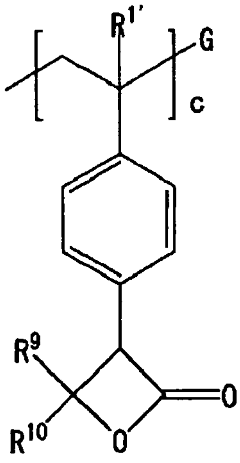
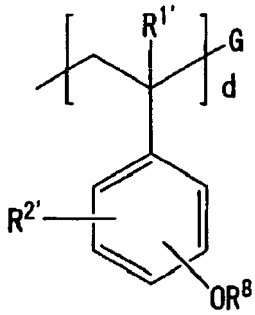

(I) (II) (III) (IV)

-X-W (7)

In the above, $R^{1'}$ and $R^{2'}$ are the same as those defined in $R^1$ and $R^2$. Preferably used are hydrogen atom and a straight-chain alkyl group having 1 to 3 carbon atoms, and especially preferable are hydrogen atom and methyl group. $R^8$ is hydrogen atom; a straight-chain, branched or cyclic alkyl group having 3 to 40 carbon atoms, preferably 3 to 30 carbon atoms, and more preferably 3 to 20 carbon atoms; a trialkylsilyl group in which each alkyl moiety has 1 to 6 carbon atoms; an oxoalkyl group in which an alkyl moiety with 4 to 20 carbon atoms; or a group of the above-mentioned formula (6). Particularly preferable is a straight-chain or branched alkyl group having 3 to 40 carbon atoms, especially a tertiary alkyl group.

In the above-mentioned definition of $R^8$, examples of the straight-chain, branched or cyclic alkyl group (preferably, tertiary alkyl group) include propyl group, isopropyl group, butyl group, isobutyl group, t-butyl group, cyclopentyl group, cyclohexyl group, cycloheptyl group, triethylcarbyl group, 1-ethylnorbonyl group, 1-methylcyclohexyl group, adamantyl group, 2-(2-methyl)adamantyl group, tert-amyl group and the like. Preferable are t-butyl group, 1-methylcyclohexyl group, adamantyl group and 2-(2-methyl)adamantyl group.

In the above-mentioned definition of $R^8$, the trialkylsilyl group has alkyl groups, each of which has 1 to 6 carbon atoms, including trimethylsilyl group, triethylsilyl group, dimethyl-tert-butylsilyl group and the like. As the oxoalkyl group, 3-oxocyclohexyl group and the like can be employed.

$R^9$ and $R^{10}$ are each hydrogen atom; a straight-chain, branched or cyclic alkyl group having 1 to 10 carbon atoms; or an aryl group having 6 to 30 carbon atoms, and $R^9$ and $R^{10}$ may be the same or different and may form a ring together.

In the above-mentioned definition of $R^9$ and $R^{10}$, examples of the straight-chain, branched or cyclic alkyl group having 1 to 10 carbon atoms and the aryl group having 6 to 30 carbon atoms include methyl group, ethyl group, propyl group, isopropyl group, butyl group, isobutyl group, t-butyl group, pentyl group, hexyl group, cyclopentyl group, 1-methylcyclopentyl group, cyclohexyl group, 1-methylcyclohexyl group, adamantyl group, triethylcarbyl group, 1-ethylnorbonyl group, 1-methylcyclohexyl group, adamantyl group, 2-(2-methyl)adamantyl group, tert-amyl group, phenyl group, 2-methylphenyl group, 2-isopropylphenyl group, 2-t-butylphenyl group, phenylmethyl group, 1-phenylethyl group and the like. In the above-mentioned definition of $R^9$ and $R^{10}$, examples of the ring formed by $R^9$ and $R^{10}$ together include cyclopropane ring, cyclobutane ring, cyclopentane ring, cyclohexane ring and the like. In the above, preferable are methyl group, phenyl group, cyclopentane ring, cyclohexane ring and the like.

G represents a halogen atom, hydrogen atom, cyano group, a straight-chain, branched or cyclic alkyl group having 1 to 10 carbon atoms, an aryl group having 6 to 30 carbon atoms, an alkylcarbonyloxy group (having an alkyl group with 1 to 10 carbon atoms), an alkyloxy group (having an alkyl group with 1 to 10 carbon atoms), a phenyloxy group, a thioether group or an amino group. In the above, hydrogen atom, a halogen atom, an alkyl group, an aryl group, an alkylcarbonyloxy group and a phenyloxy group are preferable, and in particular, hydrogen atom, chlorine atom, bromine atom, methylcarbonyloxy group, phenyl group, and phenyloxy group are preferable.

In the definition of G, the halogen atom includes chlorine atom, bromine atom and the like. The alkyl group and the aryl group include methyl group, ethyl group, propyl group, cyclohexyl group, allyl group, phenyl group and the like. In the above-mentioned definition of G, the alkylcarbonyloxy group includes methylcarbonyloxy group, ethylcarbonyloxy group and the like; the thioether group includes methyl thioether group, ethyl thioether group, phenyl thioether group and the like. Further, in the definition of G, examples of the amino group include methylamino group, dimethylamino group, trimethylamino group, ethylamino group, diethylamino group, triethylamino group, phenylamino group, and the like. Particularly preferable are chlorine atom, methyl group, phenyl group, methylcarbonyloxy group, phenyl thioether group, and phenylamino group.

In the above-mentioned unit (II), m is an integer of 0 to 10, preferably 0 to 7, and more preferably 0 to 4. In the above-mentioned units (I) to (IV), a, b, c and d are each an integer of 1 or more, preferably 1 to 20, and more preferably 1 to 10.

In formula (7), X is oxygen atom, sulfur atom, nitrogen atom, a straight-chain or branched alkyl group having 1 to 6 carbon atoms, or interatomic bond. Oxygen atom is preferable. W represents hydrogen atom, a straight-chain, branched or cyclic alkyl group having 1 to 10 carbon atoms, phenyl group, an alkoxyphenyl group having 7 to 20 carbon atoms, an alkoxycarbonyl group having 2 to 10 carbon atoms, or a group represented by the following formula (8). Particularly preferable are alkoxylphenyl group having 7 to 20 carbon atoms, alkoxycarbonyl group having 2 to 10 carbon atoms and the group of the following formula (8):

$$-R^{11}-COO-R^{8'} \qquad (8)$$

In formula (8), $R^{11}$ is a straight-chain, branched or cyclic alkylene group having 1 to 40 carbon atoms, preferably 1 to 30 carbon atoms, and more preferably 1 to 20 carbon atoms, or an arylene group having 6 to 30 carbon atoms, preferably 6 to 20 carbon atoms, and more preferably 6 to 10 carbon atoms. $R^{11}$ may contain an ether linkage or ester linkage. $R^{8'}$ is the same as that defined in the above.

In formula (7), examples of the alkoxyphenyl group include t-butoxyphenyl group, p-(1-methoxyethoxy)phenyl group, p-(1-ethoxyethoxy)phenyl group, tetrahydrofuranyloxyphenyl group, tetrahydropyranyloxyphenyl group and the like.

In formula (7), examples of the alkoxycarbonyl group include methoxycarbonyl group, ethoxycarbonyl group, t-butoxycarbonyl group, cyclohexylcarbonyl group, phenyloxycarbonyl group and the like.

In formula (8), $R^{11}$ represents methylene group, ethylene group, propylene group, isopropylene group, butylene group, isobutylene group, cyclopentylene group, cyclohexylene group, phenylene group, naphthylene group, $-C_6H_4OCH_2-$, $-C_6H_8OCH_2-$, $-C_6H_5O-$ and the like.

Thus, the groups represented by the above-mentioned formula (7) include tert-butoxycarbonyloxy group, tert-butoxycarbonylmethyloxy group, p-tert-butoxycarbonylmethoxy phenyloxy group, tert-amyloxycarbonyloxy group, tertamyloxycarbonylmethyloxy group, 1-ethoxyethoxycarbonylmethyloxy group, 2-tetrahydropyranyloxy carbonylmethyloxy group, 2-tetrahydrofuranyloxy carbonylmethyloxy group, and the like. Preferable are tert-butoxycarbonylmethyloxy group and p-tert-butoxycarbonylmethoxy phenyloxy group.

Specific examples of the acid decomposition group-containing compound include the compounds represented by the following formulas (i) to (iv). Among those compounds, those having formulas (i) and (iv) are preferable.

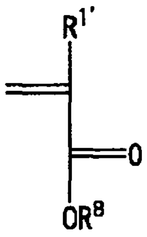
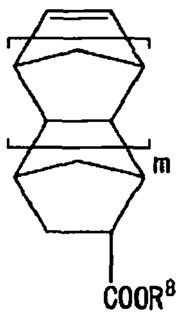
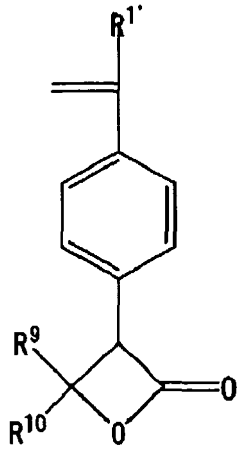
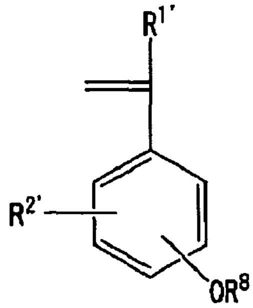

(i) (ii) (iii) (iv)

wherein $R^{1'}$, $R^{2'}$, $R^8$, $R^9$, $R^{10}$ and m are the same as those previously defined.

Specific examples of the compound represented by formula (i) include tert-butyl acrylate, tert-butyl methacrylate, 1-methylcyclohexyl acrylate, 1-methylcyclohexyl methacrylate, adamantyl acrylate, adamantyl methacrylate, 2-(2-methyl)adamantyl acrylate, 2-(2-methyl)adamantyl methacrylate, triethylcarbyl acrylate, 1-ethylnorbonyl acrylate, 1-methylcyclohexyl acrylate, tetrahydropyranyl acrylate, tetrahydropyranyl methacrylate, trimethylsilyl acrylate, dimethyl-tert-butylsilyl acrylate, and the like. Preferable are tert-butyl acrylate, tert-butyl methacrylate, 2-(2-methyl)adamantyl acrylate, 2-(2-methyl)adamantyl methacrylate, tetrahydropyranyl acrylate and tetrahydropyranyl methacrylate.

Specific examples of the compound represented by formula (ii) have the structural formulas (d1) and (g1) previously mentioned. The compounds of (d1) and (g1) are preferable.

Specific examples of the compound represented by formula (iii) include compounds represented by formulas (15) to (17) shown below. Of those compounds, those having formulas (15) and (16) are preferable.

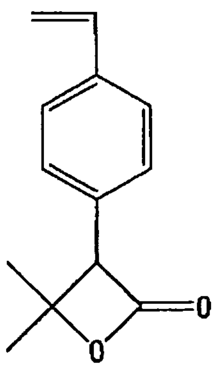
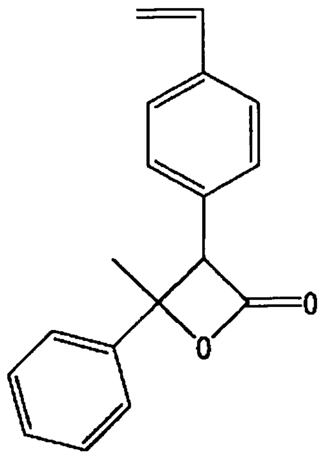
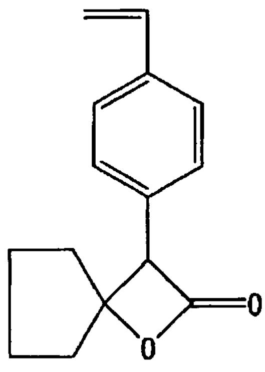

(15) (16) (17)

Specific examples of the compound represented by formula (iv) include tert-butoxy styrene, $\alpha$-methyl-tert-butoxy styrene, 4-(1-methoxyethoxy)styrene, 4-(1-ethoxyethoxy)styrene, tetrahydropyranyloxy styrene, adamantyloxy styrene, 4-(2-methyl-2-adamantyloxy)styrene, 4-(1-methylcyclohexyloxy)styrene, trimethylsilyloxy styrene, dimethyl-tert-butylsilyloxy styrene, tetrahydropyranyloxy styrene, and the like. Preferable are tert-butoxy styrene, 4-(1-ethoxyethoxy)styrene, tetrahydropyranyloxy styrene and 4-(2-methyl-2-adamantyloxy)styrene.

Other monomers than the above-mentioned monomers of formulas (I) to (IV) can also be used as the acid decomposition groups so long as the monomer structure includes a radical polymerizable unsaturated bond.

The copolymerizable monomers that can be used are as follows: for example, compounds having a radical-polymerizable unsaturated bond, selected from styrenes, acrylic esters and methacrylic esters other than the above, allyl compounds, vinyl ethers, vinyl esters, crotonic esters and the like.

Specific examples of the styrenes include benzylstyrene, trifluoromethylstyrene, acetoxystyrene, chlorostyrene, dichlorostyrene, trichlorostyrene, tetrachlorostyrene, pentachlorostyrene, bromostyrene, dibromostyrene, iodostyrene, fluorostyrene, trifluorostyrene, 2-bromo-4-trifluoromethylstyrene, 4-fluoro-3-trifluoromethylstyrene, vinyl naphthalene and the like.

Specific examples of the acrylic esters include chloroethyl acrylate, 2-hydroxyethyl acrylate, 2,2-dimethylhydroxypropyl acrylate, 5-hydroxypentyl acrylate, trimethylolpropane acrylate, glycidyl acrylate, benzyl acrylate, phenyl acrylate, naphthyl acrylate and the like.

Specific examples of the methacrylic esters include benzyl methacrylate, chlorobenzyl methacrylate, 2-hydroxyethyl methacrylate, 4-hydroxybutyl methacrylate, 5-hydroxypentyl methacrylate, 2,2-dimethyl-3-hydroxypropyl methacrylate, glycidyl methacrylate, phenyl methacrylate, naphthyl methacrylate and the like.

Specific examples of the allyl esters include allyl acetate, allyl caproate, allyl caprylate, allyl laurate, allyl palmitate, allyl stearate, allyl benzoate, allyl acetoacetate, allyl lactate, allyloxy ethanol and the like.

Specific examples of the vinyl ethers include hexylvinyl ether, octylvinyl ether, decylvinyl ether, ethylhexylvinyl ether, methoxyethylvinyl ether, ethoxyethylvinyl ether, chloroethylvinyl ether, 1-methyl-2,2-dimethylpropylvinyl ether, 2-ethylbutylvinyl ether, hydroxyethylvinyl ether, diethylene glycol vinyl ether, dimethylaminoethylvinyl ether, diethylaminoethylvinyl ether, butylaminoethylvinyl ether, benzylvinyl ether, tetrahydrofurfurylvinyl ether, vinylphenyl ether, vinyltolyl ether, vinylchlorophenyl ether, vinyl-2,4-dichlorophenyl ether, vinylnaphthyl ether, vinylanthranyl ether and the like.

Specific examples of the vinyl esters include vinyl butyrate, vinyl isobutyrate, vinyl trimethylacetate, vinyl diethylacetate, vinyl valeate, vinyl caproate, vinyl chloroacetate, vinyl dichloroacetate, vinyl methoxyacetate, vinyl butoxyacetate, vinyl phenylacetate, vinyl acetoacetate, vinyl lactate, vinyl-β-phenylbutyrate, vinyl cyclohexylcarboxylate and the like.

Specific examples of the crotonic esters include butyl crotonate, hexyl crotonate, glycerin monocronate, dimethyl itaconate, diethyl itaconate, dibutyl itaconate, dimethyl maleate, dibutyl fumarate, maleic anhydride, maleimide, acrylonitrile, methacrylonitrile, maleilonitrile and the like.

Of the above, preferably used are styrenes, acrylic esters, methacrylic esters and crotonic esters. In particular, benzylstyrene, chlorostyrene, vinylnaphthalene, benzyl acrylate, phenyl acrylate, naphthyl acrylate, benzyl methacrylate, phenyl methacrylate, naphthyl methacrylate, butyl crotonate, hexyl crotonate and maleic anhydride are preferable.

In the hyperbranched polymer of the present invention, the molar ratio (%) of repeat units of at least one selected from the compounds of formulas (I) to (IV) for constituting the acid decomposition group may be 10 to 90%, preferably 20 to 80%, and more preferably 30 to 70%. When the molar ratio is within the above-mentioned range, light exposed portions can be efficiently dissolved in an alkaline solution and preferably removed in the development process.

In the hyperbranched polymer of the present invention, the molar ratio (%) of the above-mentioned group of formulas (7) for constituting the acid decomposition group may be 10 to 50%, preferably 20 to 50%, and more preferably 30 to 50%. When the molar ratio is within the above-mentioned range, light exposed portions can be efficiently dissolved in an alkaline solution and preferably removed in the development process.

When the monomers other than those of formulas (I) to (IV) and (7) are used for constituting the acid decomposition group, the repeat units of formulas (I) to (IV) and (7) may be present in an amount of preferably 30 to 90 mol%, and more preferably 50 to 70 mol%, with respect to the entire repeat units constituting the acid decomposition group. The molar ratio falling within the above-mentioned range is preferable because functions including the etching resistance, wettability, increase of the glass transition temperature and so on can be added without any adverse effect on the efficient alkali solubility of the light exposed portions. The amount ratio of the repeat units having formulas (I) to (IV) and (7) to other repeat units in the total acid decomposition group can be controlled by adjusting the corresponding initial feeds in the step of introduction into the core portion according to the purpose.

The aforementioned acid decomposition group can be introduced by either or both of the two methods shown below.

(First method)

A first method is a method by which the acid decomposition groups represented by formulas (I) to (IV) can be introduced respectively using the previously mentioned compounds of formulas (i) to (iv) as the acid decomposition group-containing compounds.

The same transition metal complex catalyst, for example, copper (I) bipyridyl complex, as used in the synthesis

of the core portion of the hyperbranched polymer is used as a catalyst. From a lot of halocarbons present at the end of the above-mentioned core portion, the living radical polymerization with the double bond of at least one compound of any of the above-mentioned formulas (i) to (iv) is started to carry out the addition polymerization in a straight chain. To be more specific, the core portion is generally reacted with at least one compound represented by any of the formulas (i) to (iv) at 0 to 200°C for 0.1 to 30 hours in a solvent such as chlorobenzene or the like, whereby the acid decomposition group of any of the formulas (I) to (IV) is introduced to produce a hyperbranched polymer of the present invention.

The reaction scheme where an acid decomposition group is introduced into the core portion of the hyperbranched polymer prepared from chloromethyl styrene will be given as Reaction Scheme 1 by way of example:

Reaction Scheme 1

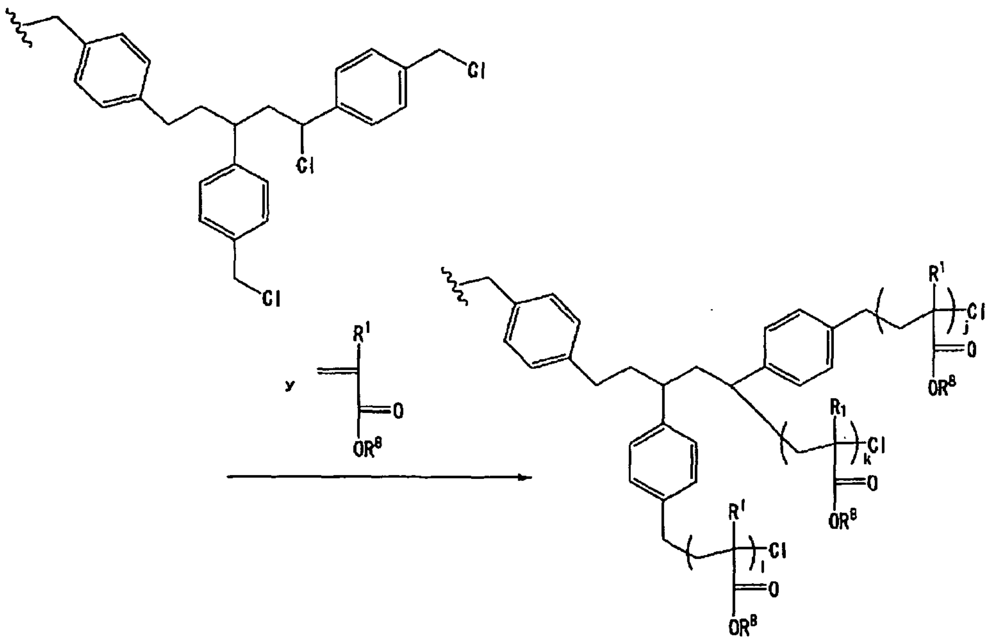

wherein y is an integer of 1 or more; j, k and 1 are each a number of 1 or more; and $R^1$ and $R^8$ are the same as those previously defined.

The group indicated by G in the above-mentioned groups (I) to (IV) can lead the introduction of the acid decomposition group by the conventional reaction with the halocarbon.

(Second method)

A second method is a method by which the acid decomposition group represented by formula (7) can be introduced using as the acid decomposition group-containing compound A-X-W, i.e., a moiety in the following Reaction Scheme 2 wherein A is a group capable of producing an anionic species, cationic species or radical species at the position of X upon elimination of A. To be more specific, the core portion is generally reacted with the moiety of A-X-W at -78 to 150°C for 0.5 to 30 hours in a solvent such as chlorobenzene or the like, whereby the acid decomposition group represented by formula (7) is incorporated to produce a hyperbranched polymer of the present invention. There are a lot of halocarbons at the end of the core portion previously synthesized, where the conventional reaction with the halocarbons may be carried out to incorporate the acid decomposition group. For instance, a substitution reaction of the X-W group for chloro group present at the end of the core portion synthesized from chloromethyl styrene is carried out as shown below:

Reaction Scheme 2: -C-Cl + A - X - W $\rightarrow$ -C-X-W

In the above-mentioned Reaction Scheme 2, A is a group capable of producing an anionic species, cationic species or radical species at the position of X upon elimination of A.

Preferably, the above-mentioned hyperbranched polymer may comprise the core portion, which is a homopolymer of the monomer of formula (1) or a copolymer of the monomer of formula (1) and at least one monomer selected from the group consisting of the monomers of formulas (2) to (5); and the acid decomposition group represented by the aforementioned formula (I), (II), (III) or (7).

It is also preferable that the above-mentioned hyperbranched polymer comprise the core portion, which is a homopolymer of the monomer of formula (1) or a copolymer of the monomer of formula (1) and at least one monomer selected from the group consisting of the monomers of formulas (2) to (4); and the acid decomposition group represented by the aforementioned formula (I), (III) or (IV).

Further, the above-mentioned hyperbranched polymer may preferably comprise the core portion, which is a copolymer having at least one monomer selected from the group consisting of the monomers represented by formulas (2), (4) and (5); and the acid decomposition group of the aforementioned formula (IV).

The introduction ratio of the acid decomposition group in the hyperbranched polymer of the present invention is preferably 0.05 or more, more preferably 0.1 or more, further preferably 0.15 or more, further more preferably 0.2 or more, still more preferably 0.3 or more, still further preferably 0.5 or more, and most preferably 0.6 or more, while preferably 20 or less, more preferably 15 or less, further preferably 10 or less, further more preferably 7 or less, still more preferably 5 or less, with respect to the number of monomers represented by formula (1) for constituting the core portion of the hyperbranched polymer. The ratio is preferably in the range of 0.05 to 20, more preferably 0.1 to 20, further preferably 0.3 to 20, further more preferably 0.3 to 15, still more preferably 0.5 to 10, and most preferably 0.6 to 5. The introduction ratio may fall within the above-mentioned range because the light exposed portion is efficiently dissolved in an alkali solution and removed while non-exposed portion can be prevented from being dissolved in the course of development, which is advantageous to the formation of fine patterns.

In the hyperbranched polymer of the present invention, the acid decomposition group for constituting the hyperbranched polymer may be converted into an acidic group such as carboxyl group, phenolic hydroxyl group or the like as a result of a partial decomposition reaction by use of a catalyst after introduced into the core portion.

Specific examples of the above-mentioned catalyst include acid catalysts such as hydrochloric acid, sulfuric acid, phosphoric acid, hydrobromic acid, p-toluenesulfonic acid, acetic acid, trifluoroacetic acid, trifluoromethanesulfonic acid, formic acid and the like; and alkaline catalysts such as sodium hydroxide, potassium hydroxide and the like. Preferably employed are acid catalysts, in particular, hydrochloric acid, p-toluenesulfonic acid, acetic acid, trifluoroacetic acid and formic acid.

Preferably, the molar ratio (%) of at least one repeat unit selected from formulas (I) to (IV) for constituting the acid decomposition group, which repeat unit has an acidic group where $R^8$ represents a hydrogen atom may be in the range of 0 to 70%, preferably 0 to 60%, and more preferably 0 to 50%, with respect to the hyperbranched polymer of the present invention. The above-mentioned amount ratio is preferable because it can favorably contribute to higher sensitivity of the resist material in the process of light exposure.

The molar ratio (%) of the group of formula (7) for constituting the acid decomposition group wherein $R^8$ represents a hydrogen atom may be in the range of 0 to 40%, preferably 0 to 30%, and more preferably 0 to 20%, with respect to the hyperbranched polymer of the present invention. The above-mentioned amount ratio is preferable because it can favorably contribute to higher sensitivity of the resist material without adversely affecting the effect of preventing the non-exposed portions from being dissolved.

To obtain the introduction ratio of the above-mentioned acid decomposition group, the molar ratio with respect to the monomer of formula (1) may be calculated from the characteristic integral value for a proton of the acid decomposition group, which can be determined by $^1$H-NMR of the product. Alternatively, the introduction ratio can be obtained by calculating in accordance with any of the following equations (a) to (c):

$$R = \frac{Cm \times (AW - CW)}{CW \times Am} \qquad \text{Equation (a)}$$

$$R = \frac{Cm \times (BW - CW)}{CW \times (Bm - X - 1)} \qquad \text{Equation (b)}$$

$$R = \frac{s}{r} + \frac{\{r \times Cm + (100 - r - s) \times Dm + s \times Em\} \times (AW - CW)}{r \times Am \times CW}$$

Equation (c)

wherein;
R is the molar ratio of the introduced acid decomposition group with respect to the monomer represented by formula (1) for constituting the core portion;
Am is the average molecular weight of the monomer having an acid decomposition group;
Bm is the average molecular weight of the molecule having a dehalogenated acid decomposition group;
Cm is the average molecular weight of the monomer represented by formula (1) for constituting the core portion;
Dm is the average molecular weight of the constituent monomer of the core portion, which monomer is other than the monomer of formula (1) and does not have an acid decomposition group;
Em is the average molecular weight of the constituent monomer of the core portion, which monomer has an acid decomposition group;
AW is the weight average molecular weight of the hyperbranched polymer where an acid decomposition group is introduced;
BW is the weight average molecular weight of the dehalogenated hyperbranched polymer;
CW is the weight average molecular weight of the core portion;
X is the atomic weight of halogen atoms present in the constituent monomers of the core portion;
r is the molar ratio (%) of the monomer having formula (1) for constituting the core portion; and
s is the molar ratio (%) of the constituent monomer of the core portion, which monomer has an acid decomposition group.

The core portion of the above-mentioned hyperbranched polymer may preferably have a branching degree (Br) of 0.1 to 0.9, more preferably 0.3 to 0.7, still more preferably 0.4 to 0.5, and most preferably 0.5. It is preferable that the degree of branching in the core portion be within the above-mentioned range because entanglement between the molecules of the obtained polymer can be reduced to suppress the surface roughness on the side wall of the patterns.

Here, the above-mentioned degree of branching can be determined by following the procedures shown below after obtaining $^1H$-NMR of the product. Using the integral ratio H1° of proton in the $-CH_2Cl$ moiety appearing at 4.6 ppm and the integral ratio H2° of proton in the -CHCl moiety appearing at 4.8 ppm, the degree of branching was calculated in accordance with the following equation (A). As the polymerization proceeds both in the moieties of $-CH_2Cl$ and -CHCl and the branching is increased, the value (Br) is approaching 0.5.

$$Br = \frac{\frac{1}{2} H1^{\circ}}{\frac{1}{2} H1^{\circ} + H2^{\circ}}$$

Equation (a)

The core portion of the hyperbranched polymer according to the present invention may preferably have a weight average molecular weight of 300 to 100,000, more preferably 500 to 80,000, still more preferably 1,000 to 100,000, further preferably 1,000 to 50,000, and most preferably 5,000 to 50,000. When the molecular weight of the core portion is within the above-mentioned range, the core portion can take a spherical shape and the solubility in the reaction solvent can be preferably ensured in the course of the reaction where the acid decomposition group is introduced. Further, excellent film forming properties can be obtained, and when the hyperbranched polymer is prepared by introducing an acid decomposition group into the core portion having the above-mentioned molecular weight, non-light exposed portions can favorably be prevented from being dissolved.

The hyperbranched polymer according to the present invention may preferably have a weight average molecular weight (Mw) of 500 to 150,000, more preferably 2,000 to 150,000, still more preferably 1,000 to 100,000, further preferably 2,000 to 60,000, and most preferably 6,000 to 60,000. The resist which contains the hyperbranched polymer with a weight average molecular weight of less than 500 may not be coated over the substrate due to the poor film forming

properties, or the patterns, if formed through the process of lithography, may not retain the shape thereof due to the low strength of the obtained patterns and the etching resistance may be lowered in the process of etching. The hyperbranched polymer with a weight average molecular weight of less than 2,000 may not provide the processed patterns with a strength sufficient enough to retain the shape of the patterns. When the weight average molecular weight exceeds 150,000, the size of the polymer molecule may have an adverse effect on the surface roughness.

The previously mentioned weight average molecular weight (Mw) can be determined by preparing a tetrahydrofuran solution with a concentration of 0.05% by mass, and carrying out gel permeation chromatography (GPC) at 40°C. Tetrahydrofuran is used as a solvent for the mobile phase and styrene can be employed as a reference material.

When the hyperbranched polymer of the present invention is synthesized using a transition metal complex as a catalyst, the obtained hyperbranched polymer may contain the transition metal. The transition metal may be mixed into the hyperbranched polymer of the present invention usually in a concentration of 5 to 7 ppm, which depends on the kind and the amount of catalyst used. The metal derived from the catalyst may be preferably removed to such an extent that the concentration of the metal mixed into the hyperbranched polymer of the present invention will be decreased to less than 100 ppb, preferably less than 80 ppb, and more preferably less than 60 ppb. When the concentration of the metal derived from the catalyst is 100 ppb or more, light emitted in the process of light exposure may be absorbed by the metal element mixed into the polymer, which will decrease the sensitivity of the resist, and thereby adversely affecting the throughput. Further, when the resist is subjected to dry ashing by use of $O_2$ plasma or the like for removal of the resist material after the dry etching process, the metal element, if mixed, may be attached to the substrate or scattered, which will variously exert an adverse effect on the post-process. The concentration of metal element can be determined by ICPMAS, (for example, using a spectrometer MIP-MS P-6000, made by Hitachi, Ltd.). As means for removing the metal element, filtration can be carried out, for example, using an ion exchange membrane (e.g., "Protego CP" available from Nihon Mykrolis Corporation) and a membrane film (e.g., Millipore Filter available from Millipore Corporation) alone or in combination. A pressure may be applied in the course of filtration, for example, so that the flow rate of a polymer solution is 0.5 to 10 ml/min. The pressure application favors the efficiency in removal of the metal element.

The solubility of the hyperbranched polymer of the present invention in an alkali aqueous solution is evaluated, for example, in such a manner that after a predetermined area of a sample thin layer with a given thickness formed on a silicon wafer is irradiated with electron beams at an intensity of 50 to 5000 mJ/cm$^2$ using an electron beam lithography system, or a predetermined area of the sample thin layer is irradiated with ultraviolet light having a wavelength of 245 nm at an intensity of 0 to 200 mJ/cm$^2$ using a discharge-tube type UV irradiation apparatus, the sample thin layer is subjected to a heat treatment and immersed in an alkali aqueous solution, and then washed with water and dried, and thereafter the state of the dried thin layer is observed using a digital microscope or the film thickness was measured using a thin-film measuring apparatus.

The surface roughness of the light exposed surface can be determined, for example, by the method described in Masao NAGASE, *Metrology of nano-structures using atomic force microscopy and its application to device and process for measurement,*.Doctoral dissertation of Waseda University 2475, pp99-107, (1996). To be specific, it is possible to estimate the surface roughness based on the roughness of a surface irradiated with an exposure corresponding to 30% of the electron beam or ultraviolet light exposure which shows solubility in the alkali aqueous solution by use of the electron beam lithography system or the discharge-tube type UV irradiation apparatus. Using the sample prepared in the same manner as in the evaluation of the solubility in alkaline aqueous solution, the surface roughness can be determined by measuring a value of ten-point height of irregularities in accordance with JIS B0601-1994 as an index of surface roughness, using an atomic force microscopy.

The hyperbranched polymer of the present invention obtainable by the production method according to the present invention has a core portion with a highly branched structure, so that the intermolecular entanglement is less when compared with linear polymers and the swelling performance in solvents is also less when compared with the molecular structure having a cross-linked main chain, thereby preventing the formation of large-sized molecular aggregates that would cause the surface roughness of the side wall of patterns. In addition, the hyperbranched polymer of the present invention has an acid decomposition group at the end of the molecule, so that in the process of photolithography a decomposition reaction occurs at a light exposed portion by the action of an acid generated by a photoacid generator to produce a hydrophilic group. As a result, the hyperbranched polymer can form a micelle structure having a lot of hydrophilic groups on the spherical surface of the molecule. Owing to the above-mentioned structure, the hyperbranched polymer can be efficiently dissolved in an alkaline aqueous solution, thereby forming minute patterns. Therefore, the hyperbranched polymer can be preferably used as a base resin for the resist composition to be shown below.

(Resist Composition)

The resist composition of the present invention comprises at least the above-mentioned hyperbranched polymer of the present invention, optionally together with a photoacid generator. The resist composition may further comprise an acid diffusion inhibitor (acid scavenger), a surfactant, other ingredients and a solvent, if necessary.

The amount of the above-mentioned hyperbranched polymer of the present invention is preferably in the range of 4 to 40 mass%, more preferably 4 to 20 mass%, with respect to the total mass of the resist composition.

The above-mentioned photoacid generator is not particularly limited so far as it can generate an acid when irradiated with ultraviolet light, X-ray, electron beam or the like. The photoacid generator may be appropriately chosen from the conventional ones, for example, onium salts, sulfonium salts, halogen-containing triazine compounds, sulfone compounds, sulfonate compounds, aromatic sulfonate compounds, sulfonate compounds of N-hydroxyimide, and the like.

The above-mentioned onium salts include, for example, diaryl iodonium salts, triaryl selenonium salts, triaryl sulfonium salts and the like. Examples of the above-mentioned diaryl iodonium salts are diphenyl iodonium trifluoromethanesulfonate, 4-methoxyphenyl phenyl iodonium hexafluoroantimonate, 4-methoxyphenyl phenyl iodonium trifluoromethanesulfonate, bis(4-tert-butylphenyl) iodonium tetrafluoroborate, bis(4-tert-butylphenyl) iodonium hexafluorophosphate, bis(4-tert-butylphenyl) iodonium hexafluoroantimonate, bis(4-tert-butylphenyl) iodonium trifluoromethanesulfonate, and the like. Examples of the above-mentioned triaryl selenonium salts are triphenyl selenonium hexafluorophosphonium salt, triphenyl selenonium fluoroborate salt, triphenyl selenonium hexafluoroantimonate salt and the like. Examples of the above-mentioned triaryl sulfonium salts are triphenyl sulfonium hexafluorophosphonium salt, triphenylsulfonium hexafluoroantimonate salt, diphenyl-4-thiophenoxyphenyl sulfonium hexafluoroantimonate salt, diphenyl-4-thiophenoxyphenyl sulfonium pentafluorohydroxyantimonate salt, and the like.

The above-mentioned sulfonium salts include, for example, triphenyl sulfonium hexafluorophosphate, triphenyl sulfonium hexafluoroantimonate, triphenyl sulfonium trifluoromethanesulfonate, 4-methoxyphenyl diphenyl sulfonium hexafluoroantimonate, 4-methoxyphenyl diphenyl sulfonium trifluoromethanesulfonate, p-tolyldiphenyl sulfonium trifluoromethanesulfonate, 2,4,6-trimethylphenyl diphenyl sulfonium trifluoromethanesulfonate, 4-tert-butylphenyl diphenyl sulfonium trifluoromethanesulfonate, 4-phenylthiophenyl diphenyl sulfonium hexafluorophosphate, 4-phenylthiophenyl diphenyl sulfonium hexafluoroantimonate, 1-(2-naphthoylmethyl)thiolanium hexafluoroantimonate, 1-(2-naphthoylmethyl)thiolanium trifluoromethanesulfonate, 4-hydroxy-1-naphthyldimethyl sulfonium hexafluoroantimonate, 4-hydroxy-1-naphthyldimethyl sulfonium trifluoromethanesulfonate, and the like.

The above-mentioned halogen-containing triazine compounds include, for example, 2-methyl-4,6-bis(trichloromethyl)-1,3,5-triazine, 2,4,6-tris(trichloromethyl)-1,3,5-triazine, 2-phenyl-4,6-bis(trichloromethyl)-1,3,5-triazine, 2-(4-chlorophenyl)-4,6-bis(trichloromethyl)-1,3,5-triazine, 2-(4-methoxyphenyl)-4,6-bis(trichloromethyl)-1,3,5-triazine, 2-(4-methoxy-1-naphthyl)-4,G-bis(trichloromethyl)-1,3,5-triazine, 2-(benzo[d][1,3]dioxolan-5-yl)-4,6-bis(trichloromethyl)-1,3,5-triazine, 2-(4-methoxystyryl)-4,6-bis(trichloromethyl)-1,3,5-triazine, 2-(3,4,5-trimethoxystyryl)-4,6-bis(trichloromethyl)-1,3,5-triazine, 2-(3,4-dimethoxystyryl)-4,6-bis(trichloromethyl)-1,3,5-triazi-ne, 2-(2,4-dimethoxystyryl)-4,6-bis (trichloromethyl)-1,3,5-triazine, 2-(2-methoxystyryl)-4,6-bis(trichloromethyl)-1,3,5-triazine, 2-(4-butoxystyryl)-4,6-bis (trichloromethyl)-1,3,5-triazine, 2-(4-pentyloxystyryl)-4,6-bis(trichloromethyl)-1,3,5-triazine, and the like.

The above-mentioned sulfone compounds include, for example, diphenyl disulfone, di-p-tolyl disulfone, bis (phenylsulfonyl)diazomethane, bis(4-chlorophenylsulfonyl)diazomethane, bis(p-tolylsulfonyl)diazomethane, bis(4-tert-butylphenylsulfonyl)diazomethane, bis(2,4-xylylsulfonyl)diazomethane, bis(cyclohexylsulfonyl)diazomethane, (benzoyl) (phenylsulfonyl)diazomethane, phenylsulfonyl acetophenone, and the like.

The above-mentioned aromatic sulfonate compounds include, for example, α-benzoylbenzyl p-toluenesulfonate (commonly known as benzointosylate), β-benzoyl-β-hydroxyphenetyl p-toluenesulfonate (commonly known as α-methylol benzointosylate), 1,2,3-benzenetriyl trismethanesulfonate, 2,6-dinitrobenzyl p-toluenesulfonate, 2-nitrobenzyl p-toluenesulfonate, 4-nitrobenzyl p-toluenesulfonate, and the like.

The above-mentioned sulfonate compounds of N-hydroxyimide include, for example, N-(phenylsulfonyloxy) succinimide, N-(triffuoromethylsulfonyloxy)-succinimide, N-(p-chlorophenylsulfonyloxy)succinimide, N-(cyclohexylsulfonyloxy)-succinimide, N-(1-naphthylsulfonyloxy)succinimide, N-(benzylsulfonyloxy)-succinimide, N-(10-camphorsulfonyloxy)succinimide, N-(trifluoromethylsulfonyloxy)phthalimide, N-(trifluoromethylsulfonyloxy)-5-norbornene-2,3-dicarboxyimide, N-(trifluoromethylsulfonyloxy)naphthalimide, N-(10-camphorsulfonyloxy)-naphthalimide, and the like.

As the above-mentioned photoacid generator, sulfonium salts, in particular, triphenyl sulfonium trifluoromethanesulfonate; and sulfone compounds, in particular, bis(4-tert-butylphenylsulfonyl)diazomethane and bis(cyclohexylsulfonyl)diazomethane are preferable.

The photoacid generators mentioned above can be used alone or in combination. The amount of the aforementioned photoacid generator is not particularly limited, but may be appropriately determined according to the application and preferably in the range of 0.1 to 30 parts by mass, more preferably 0.1 to 10 parts by mass, with respect to 100 parts by mass of the hyperbranched polymer of the present invention.

The above-mentioned acid diffusion inhibitor is not particularly limited so long as it can inhibit the acid that has been generated from the acid generator by light exposure from causing the phenomenon of diffusion within the resist coating to suppress the occurrence of undesired chemical reactions in non-exposed portions. Any acid diffusion inhibitor may appropriately be selected depending upon the application from the conventional ones, for example, nitrogen-containing compounds having one nitrogen atom in one molecule thereof, compounds having two nitrogen atoms in one

molecule thereof, polyamino compounds and polymers having three or more nitrogen atoms, amide group-containing compounds, urea compounds, nitrogen-containing heterocyclic compounds and the like.

The nitrogen-containing compounds having one nitrogen atom in one molecule thereof include, for example, mono(cyclo)alkylamine, di(cyclo)alkylamine, tri(cyclo)alkylamine, aromatic amine, and the like. Examples of the above-mentioned mono(cyclo)alkylamine include n-hexylamine, n-heptylamine, n-octylamine, n-nonylamine, n-decylamine, cyclohexylamine and the like. Examples of the above-mentioned di(cyclo)alkylamine include di-n-butylamine, di-n-pentylamine, di-n-hexylamine, di-n-heptylamine, di-n-octylamine, di-n-nonylamine, di-n-decylamine, cyclohexylmethylamine and the like. Examples of the above-mentioned tri(cyclo)alkylamine include triethylamine, tri-n-propylamine, tri-n-butylamine, tri-n-pentylamine, tri-n-hexylamine, tri-n-heptylamine, tri-n-octylamine, tri-n-nonylamine, tri-n-decylamine, cyclohexyldimethylamine, methyldicyclohexylamine, tricyclohexylamine and the like. Examples of the above-mentioned aromatic amine include aniline, N-methylaniline, N,N-dimethylaniline, 2-methylaniline, 3-methylaniline, 4-methylaniline, 4-nitroaniline, diphenylamine, triphenylamine, naphthylamine, and the like.

The above-mentioned compounds having two nitrogen atoms in one molecule thereof include, for example, ethylenediamine, N,N,N',N'-tetramethylethylenediamine, tetramethylenediamine, hexamethylenediamine, 4,4'-diaminodiphenylmethane, 4,4'-diaminodiphenyl ether, 4,4'-diaminobenzophenone, 4,4'-diaminodiphenylamine, 2,2-bis(4-aminophenyl)propane, 2-(3-aminophenyl)-2-(4-aminophenyl)propane, 2-(4-aminophenyl)-2-(3-hydroxyphenyl)propane, 2-(4-aminophenyl)-2-(4-hydroxyphenyl)propane, 1,4-bis[1-(4-aminophenyl)-1-methylethyl]benzene, 1,3-bis[1-(4-aminophenyl)-1-methylethyl]benzene, bis(2-dimethylaminoethyl)ether, bis(2-diethylaminoethyl)ether, and the like.

The above-mentioned polyamino compounds and polymers having three or more nitrogen atoms include, for example, polyethyleneimine, polyallylamine, N-(2-dimethylaminoethyl)acrylamide polymer and the like.

The above-mentioned amide group-containing compounds include, for example, N-t-butoxycarbonyl di-n-octylamine, N-t-butoxycarbonyl di-n-nonylamine, N-t-butoxycarbonyl di-n-decylamine, N-t-butoxycarbonyl dicyclohexylamine, N-t-butoxycarbonyl-1-adamantylamine, N-t-butoxycarbonyl-N-methyl-1-adamantylamine, N,N-di-t-butoxycarbonyl-1-admantylamine, N,N-di-t-butoxycarbonyl-N-methyl-1-adamantylamine, N-t-butoxycarbonyl-4,4'-diaminodiphenylmethane, N,N'-di-t-butoxycarbonyl hexamethylenediamine, N,N,N',N'-tetra-t-butoxycarbonyl hexamethylenediamine, N,N'-di-t-butoxycarbonyl-1,7-diaminoheptane, N,N'-di-t-butoxycarbonyl-1,8-diaminooctane, N,N'-di-t-butoxycarbonyl-1,9-diaminononane, N,N'-di-t-butoxycarbonyl-1,10-diaminodecane, N,N'-di-t-butoxycarbonyl-1,12-diaminododecane, N,N'-di-t-butoxycarbonyl-4,4'-diaminodiphenylmethane, N-t-butoxycarbonyl benzimidazole, N-t-butoxycarbonyl-2-methylbenzimidazole, N-t-butoxycarbonyl-2-phenylbenzimidazole, formamide, N-methylformamide, N,N-dimethylformamide, acetoamide, N-methylacetoamide, N,N-dimethylacetoamide, propionamide, benzamide, pyrrolidone, N-methylpyrrolidone, and the like.

The above-mentioned urea compounds include, for example, urea, methylurea, 1,1-dimethylurea, 1,3-dimethylurea, 1,1,3,3-tetramethylurea, 1,3-diphenylurea, tri-n-butylthiourea, and the like.

The above-mentioned nitrogen-containing heterocyclic compounds include, for example, imidazole, 4-methylimidazole, 4-methyl-2-phenylimidazole, benzimidazole, 2-phenylbenzimidazole, pyridine, 2-methylpyridine, 4-methylpyridine, 2-ethylpyridine, 4-ethylpyridine, 2-phenylpyridine, 4-phenylpyridine, 2-methyl-4-phenylpyridine, nicotine, nicotinic acid, nicotinamide, quinoline, 4-hydroxyquinoline, 8-oxyquinoline, acridine, piperazine, 1-(2-hydroxyethyl)piperazine, pyrazine, pyrazole, pyridazine, quinozaline, purine, pyrrolidine, piperidine, 3-piperidino-1,2-propanediol, morpholine, 4-methylmorpholine, 1,4-dimethylpiperazine, 1,4-diazabicyclo[2.2.2]octane, and the like.

The above-mentioned acid diffusion inhibitors can be used alone or in combination. The amount of the aforementioned acid diffusion inhibitor is not particularly limited, but may be appropriately determined according to the application and preferably in the range of 0.1 to 1000 parts by mass, more preferably 0.5 to 10 parts by mass, with respect to 100 parts by mass of the above-mentioned photoacid generator.

Further, the surfactant mentioned above is not particularly limited so long as it has the effect of improving the coating properties, striation, development performance or the like. Any surfactant may appropriately be selected depending upon the application from the conventional ones, for example, polyoxyethylene alkyl ethers, polyoxyethylene alkylallyl ethers, sorbitan fatty acid esters, nonionic surfactants of polyoxyethylene sorbitan fatty acid esters, fluorine-containing surfactants, silicon-containing surfactants and the like.

Examples of the above-mentioned polyoxyethylene alkyl ethers include polyoxyethylene lauryl ether, polyoxyethylene stearyl ether, polyoxyethylene cetyl ether, polyoxyethylene oleyl ether, and the like. Examples of the above-mentioned polyoxyethylene alkylallyl ethers include polyoxyethylene octylphenol ether, polyoxyethylene nonylphenol ether, and the like. Examples of the above-mentioned sorbitan fatty acid esters include sorbitan monolaurate, sorbitan monopalmitate, sorbitan monostearate, sorbitan monooleate, sorbitan trioleate, sorbitan tristearate, and the like. Examples of the nonionic surfactants of polyoxyethylene sorbitan fatty acid esters include polyoxyethylene sorbitan monolaurate, polyoxyethylene sorbitan monopalmitate, polyoxyethylene sorbitan monostearate, polyoxyethylene sorbitan trioleate, polyoxyethylene sorbitan tristearate, and the like. Examples of the above-mentioned fluorine-containing surfactants include EFTOP EF301, EF303 and EF352 (made by New Akita Chemical Company); MEGAFAC F171, F173, F176, F189 and R08 (made by Dainippon Ink and Chemicals, Incorporated); Fluorad FC430 and FC431 (made by

Sumitomo 3M Limited); AsahiGuard AG710, Surflon S-382, SC101, SC102, SC103, SC104, SC105 and SC106 (made by Asahi Glass Co., Ltd.) and the like. Examples of the above-mentioned silicon-containing surfactants include organosiloxane polymer KP341 (made by Shin-Etsu Chemical Co., Ltd.) and the like.

The above-mentioned surfactants may be used alone or in combination. The amount ratio of the surfactant is not particularly limited, but may be appropriately determined according to the purpose. The amount of surfactant may be preferably in the range of 0.0001 to 5 parts by mass, more preferably 0.0002 to 2 parts by mass, with respect to 100 parts by mass of the hyperbranched polymer of the present invention.

As other ingredients, there can be employed, for example, a sensitizer, a solubility control agent, an acid dissociation group-containing additive, an alkali-soluble resin, a dye, a pigment, an auxiliary adhesive, an antifoaming agent, a stabilizer, an antihalation agent, and the like.

The above-mentioned sensitizer is not particularly limited so long as it can absorb the radiation energy and send it to the photoacid generator, thereby acting to increase the amount of generated acid and having the effect of enhancing the apparent sensitivity of the resist composition. For example, there are acetophenones, benzophenones, naphthalenes, biacetyl, eosin, rose bengal, pyrenes, anthracenes, phenothiazines and the like. Those sensitizers can be used alone or in combination.

The above-mentioned solubility control agent is not particularly limited so long as it can more suitably control the contrast in solubilities and the dissolution rate in the resist. For example, polyketones and polyspiroketals and the like can be employed. Those solubility control agents can be used alone or in combination.

There is no particular restriction on the above-mentioned acid dissociation group-containing additive if the dry etching resistance, the shape of patterns, the adhesion to the substrate and the like can be further enhanced by the additive. Examples of the acid dissociation group-containing additive include t-butyl 1-adamantane carboxylate, t-butoxycarbonylmethyl 1-adamantane carboxylate, di-t-butyl 1,3-adamantane dicarboxylate, t-butyl 1-adamantane acetate, t-butoxycarbonylmethyl 1-adamantane acetate, di-t-butyl 1,3-adamantane diacetate, t-butyl deoxycholate, t-butoxycarbonylmethyl deoxycholate, 2-ethoxyethyl deoxycholate, 2-cyclohexyloxyethyl deoxycholate, 3-oxocyclohexyl deoxycholate, tetrahydropyranyl deoxycholate, mevalonolactone deoxycholate ester, t-butyl lithocholate, t-butoxycarbonylmethyl lithocholate, 2-ethoxyethyl lithocholate, 2-cyclohexyloxyethyl lithocholate, 3-oxocyclohexyl lithocholate, tetrahydropyranyl lithocholate, mevalonolactone lithocholate ester, and the like. Those solubility control agents can be used alone or in combination.

The above-mentioned alkali-soluble resin is not particularly limited so long as it can improve the alkali-solubility of the resist composition according to the present invention. For example, poly(4-hydroxystyrene), partially hydrogenated poly(4-hydroxystyrene), poly(3-hydroxystyrene), poly(3-hydroxystyrene), 4-hydroxystyrene - 3-hydroxystyrene copolymer, 4-hydroxystyrene - styrene copolymer, novolac resin, polyvinyl alcohol, polyacrylic acid and the like can be employed, which may generally have a weight average molecular weight (Mw) of 1,000 to 1,000,000, preferably 2,000 to 100,000. Those alkali-soluble resins may be used alone or in combination.

The above-mentioned dye or pigment is capable of making latent images corresponding to the light exposed portions visible to lessen the effects caused by halation that would occur during the light exposure. Further, the above-mentioned auxiliary adhesive can improve the adhesion to the substrate.

The previously mentioned solvent is not particularly limited so long as it can dissolve the above ingredients therein. The solvent may be appropriately selected from those that can be used safely for the resist composition, for example, from ketones, cyclic ketones, propylene glycol monoalkyl ether acetates, alkyl 2-hydroxypropionates, alkyl 3-alkoxypropionates and others.

Examples of the above-mentioned ketones include methyl isobutyl ketone, methyl ethyl ketone, 2-butanone, 2-pentanone, 3-methyl-2-butanone, 2-hexanone, 4-methyl-2-pentanone, 3-methyl-2-pentanone, 3,3-dimethyl-2-butanone, 2-heptanone, 2-octanone and the like. Examples of the above-mentioned cyclic ketones include cyclohexanone, cyclopentanone, 3-methyl cyclopentanone, 2-methyl cyclohexanone, 2,6-dimethyl cyclohexanone, isophorone and the like. Examples of the above-mentioned propylene glycol monoalkyl ether acetates include propylene glycol monomethyl ether acetate, propylene glycol monoethyl ether acetate, propylene glycol mono-n-propyl ether acetate, propylene glycol mono-i-propyl ether acetate, propylene glycol mono-n-butyl ether acetate, propylene glycol mono-i-butyl ether acetate, propylene glycol mono-sec-butyl ether acetate, propylene glycol mono-t-butyl ether acetate, and the like. Examples of the above-mentioned alkyl 2-hydroxypropionates include methyl 2-hydroxypropionate, ethyl 2-hydroxypropionate, n-propyl 2-hydroxypropionate, i-propyl 2-hydroxypropionate, n-butyl 2-hydroxypropionate, i-butyl 2-hydroxypropionate, sec-butyl 2-hydroxypropionate, t-butyl 2-hydroxypropionate, and the like. Examples of the above-mentioned alkyl 3-alkoxypropionates include methyl 3-methoxypropionate, ethyl 3-methoxypropionate, methyl 3-ethoxypropionate, ethyl 3-ethoxypropionate, and the like.

Examples of other solvents as mentioned above include n-propyl alcohol, i-propyl alcohol, n-butyl alcohol, t-butyl alcohol, cyclohexanol, ethylene glycol monomethyl ether, ethylene glycol monoethyl ether, ethylene glycol mono-n-propyl ether, ethylene glycol mono-n-butyl ether, diethylene glycol dimethyl ether, diethylene glycol diethyl ether, diethylene glycol di-n-propyl ether, diethylene glycol di-n-butyl ether, ethylene glycol monomethyl ether acetate, ethylene

glycol monoethyl ether acetate, ethylene glycol mono-n-propyl ether acetate, propylene glycol, propylene glycol monomethyl ether, propylene glycol monoethyl ether, propylene glycol mono-n-propyl ether, ethyl 2-hydroxy-2-methylpropionate, ethyl ethoxyacetate, ethyl hydroxyacetate, methyl 2-hydroxy-3-methyl butyrate, 3-methoxybutyl acetate, 3-methyl-3-methoxybutyl acetate, 3-methyl-3-methoxybutyl propionate, 3-methyl-3-methoxybutyl butyrate, ethyl acetate, n-propyl acetate, n-butyl acetate, methyl acetoacetate, ethyl acetoacetate, methyl pyruvate, ethyl pyruvate, N-methyl pyrrolidone, N,N-dimethylformamide, N,N-dimethylacetamide, benzylethyl ether, di-n-hexyl ether, diethylene glycol monomethyl ether, diethylene glycol monoethyl ether, γ-butyrolactone, toluene, xylene, caproic acid, caprylic acid, octane, decane, 1-octanol, 1-nonanol, benzyl alcohol, benzyl acetate, ethyl benzoate, diethyl oxalate, diethyl maleate, ethylene carbonate, propylene carbonate, and the like. Those solvents may be used alone or in combination.

The resist composition of the present invention can be subjected to patterning by light exposure in a pattern-wise fashion and the subsequent development. The resist composition of the present invention can be preferably used in a variety of fields because the resist composition can conform to the light sources of electron beams, deep ultraviolet (DUV) and extreme ultraviolet (EUV) which are required to produce nano-order surface smoothness, thereby producing minute patterns for fabrication of the very large scale integrated circuits (VLSI). After light exposed and heated, the resist composition of the present invention is dissolved in an alkaline developer solution. When the light exposed surface is then washed with water, the light exposed surface does not substantially bear any resist portion still remaining insoluble, thereby obtaining nearly vertical edges.

Examples

(Example 1A)

Synthesis of Hyperbranched Polymer

In a 50 mL reaction vessel, 21 mmol of chloromethyl styrene as a reactive monomer, and 2.1 mmol of 2,2-bipyridyl and 1.1 mmol of copper (I) chloride as a catalyst were placed together with 8 mL of chlorobenzene as a solvent. After the atmosphere in the reaction vessel was replaced with argon, a polymerization reaction was carried out with stirring at 115°C for one hour. With the addition of 50 mL of tetrahydrofuran to the obtained reaction liquid, the resultant polymer was diluted and dissolved. After that, the reaction mixture was filtered through activated alumina to remove the catalyst. After the obtained filtrate was concentrated, the polymer was precipitated by the addition of 200 mL of methanol and the supernatant fluid was eliminated, thereby removing the unreacted monomers and the reaction solvent. Subsequently, the precipitated polymer was dissolved in 20 mL of tetrahydrofuran, and thereafter reprecipitated two times with the addition of 500 mL of methanol, so that a polymer 1 was synthesized (in a 75% yield). The above is the step of synthesizing the hyperbranched polymer previously mentioned.

The weight average molecular weight (Mw) and the degree of branching (Br) of the obtained polymer 1 were measured by the methods shown below. The results are shown in Table 1A.

<Measurement of Weight Average Molecular Weight (Mw)>

The weight average molecular weight (Mw) of the hyperbranched polymer was determined by preparing a tetrahydrofuran solution containing 0.05 mass% of polymer and subjecting the solution to gel permeation chromatography (GPC) at 40°C. Tetrahydrofuran was used as a solvent for the mobile phase, and styrene was used as a reference material.

<Degree of Branching>

The degree of branching of the hyperbranched polymer can be determined from the results of $^1$H-NMR, of the resultant product as shown below. Using the integral ratio H1° of proton in the $-CH_2Cl$ moiety appearing at 4.6 ppm and the integral ratio H2° of proton in the -CHCl moiety appearing at 4.8 ppm, the degree of branching was calculated in accordance with the following equation (A). As the polymerization proceeds both in the moieties of $-CH_2Cl$ and -CHCl to increase the branching, the value (Br) is approaching 0.5.

$$Br = \frac{\frac{1}{2} H1^{\circ}}{\frac{1}{2} H1^{\circ} + H2^{\circ}} \quad \text{Equation (a)}$$

Then, 1 g of the above-mentioned polymer 1 as a starting polymer, 6.5 mmol of p-tert-butoxy styrene as an acid decomposition group-containing compound, and 3.2 mmol of 2,2-bipyridyl and 1.6 mmol of copper (I) chloride as a catalyst were placed in a 50 mL reaction vessel together with 8 mL of chlorobenzene as a solvent. After the atmosphere in the reaction vessel was replaced with argon, a polymerization was carried out with stirring at 125°C for 30 minutes. With the addition of 50 mL of tetrahydrofuran to the obtained reaction liquid, the resultant polymer was diluted and dissolved. After that, the reaction mixture was filtered through activated alumina to remove the catalyst. After the obtained filtrate was concentrated, the polymer was precipitated by the addition of 200 mL of methanol and the supernatant fluid was eliminated, thereby removing the unreacted monomers and the reaction solvent. Subsequently, the precipitated polymer was dissolved in 20 mL of tetrahydrofuran, and thereafter reprecipitated two times with the addition of 500 mL of methanol, thereby synthesizing a desired acid decomposition group-introduced hyperbranched polymer, which is represented by the formula shown below. The above is the step of introducing the acid decomposition group previously mentioned.

The amount of added acid decomposition group (introduced amount) in the obtained hyperbranched polymer where the acid decomposition group is introduced was determined by the following method. The results are shown in Table 1A.

<Amount of Added Acid Decomposition Group (Introduced Amount)>

To determine the amount of added acid decomposition group, the integral value for a proton characteristic of the acid decomposition group was obtained from $^1$H-NMR of the product and the ratio with respect to the number of styrene derivatives which are constituent units of the hyperbranched polymer was calculated.

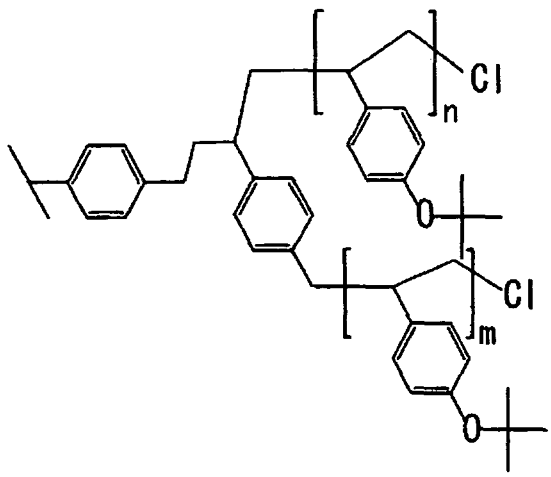

wherein n is a number of 1 or more, and m is a number of 1 or more.

Example 2A

Synthesis of Hyperbranched Polymer

The same procedure as in Example 1 was repeated to carry out the polymerization except that the amount of catalyst was increased by five times, the reaction temperature was changed to 125°C, and the reaction time was changed

to 30 minutes in the step of synthesizing the hyperbranched polymer, so that a polymer 2 was synthesized (in a 77% yield). The weight average molecular weight (Mw) and the degree of branching (Br) of the obtained polymer 2 were measured in the same manner as in Example 1. The results are shown in Table 1A.

The same procedure as in Example 1 was repeated except that 1 g of the polymer 2 was used as the starting polymer, the amount of p-tert-butoxy styrene as an acid decomposition group-containing compound was changed to 65 mmol, and the reaction time was changed to 3 hours to carry out the polymerization with p-tert-butoxy styrene and the subsequent purification in the step of introducing the acid decomposition group. Thus, a desired acid decomposition group-introduced hyperbranched polymer was synthesized.

The amount of added acid decomposition group (introduced amount) was obtained in the same manner as in Example 1. The results are shown in Table 1A.

Example 3A

Synthesis of Hyperbranched Polymer

The same procedure as in Example 1 was repeated except that the amount of catalyst was increased by four times, the reaction temperature was changed to 125°C, and the reaction time was set to one hour in the step of synthesizing the hyperbranched polymer, so that a polymer 3 was synthesized (in a 78% yield).

The weight average molecular weight (Mw) and the degree of branching (Br) of the obtained polymer 3 were measured in the same manner as in Example 1. The results are shown in Table 1A.

The same procedure as in Example 1 was repeated except that 1 g of the polymer 3 was used as the starting polymer, 65 mmol of p-ethoxy ethoxy styrene was used as an acid decomposition group-containing compound, and the reaction time was changed to 3 hours to carry out the polymerization with p-ethoxy ethoxy styrene and the subsequent purification in the step of introducing the acid decomposition group. Thus, a desired acid decomposition group-introduced hyperbranched polymer was synthesized.

The amount of added acid decomposition group (introduced amount) was obtained in the same manner as in Example 1. The results are shown in Table 1A.

Example 4A

In a 50 mL reaction vessel, 1 g of the polymer 3 as a starting polymer, 13.0 mmol of hydroquinone tert-butyl ether as an acid decomposition group-containing compound, and 13.0 mmol of NaH were placed. With the addition of 30 mL of tetrahydrofuran as a solvent, the mixture was subjected to a polymerization reaction under reflux at 70°C for 5 hours. After the addition of 200 mL of methanol to the reaction product, the precipitated polymer was separated by decantation, washed with water and then dried. Thus, a desired acid decomposition group-introduced hyperbranched polymer was synthesized, which is represented by the formula shown below. The above is the step of introducing the acid decomposition group as previously mentioned.

The amount of added acid decomposition group (introduced amount) was obtained in the same manner as in Example 1. The results are shown in Table 1A.

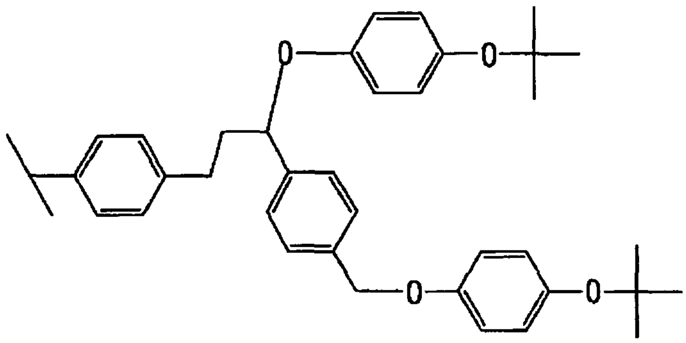

Example 5A

The same procedure as in Example 4 was repeated except that 65 mmol of tert-butyl 4-hydroxyphenyloxyacetate was used as an acid decomposition group-containing compound, and the reaction time was changed to 3 hours to carry

out the polymerization with tert-butyl 4-hydroxyphenyloxyacetate and the subsequent purification in the step of introducing the acid decomposition group. Thus, a desired acid decomposition group-introduced hyperbranched polymer was synthesized.

The amount of added acid decomposition group (introduced amount) was obtained in the same manner as in Example 1. The results are shown in Table 1A.

Table 1A

| | Hyper-branched Polymer | Acid Decomposition Group-Containing Compound | | Weight Average Molecular Weight (Mw) | Degree of Branching |
|---|---|---|---|---|---|
| | | Name | Added amount (times) | | |
| Ex. 1A | Polymer 1 | p-tert-butoxy styrene | 0.3 | 1,000 | 0.10 |
| Ex. 2A | Polymer 2 | p-tert-butoxy styrene | 5 | 10,000 | 0.45 |
| Ex. 3A | Polymer 3 | p-ethoxy ethoxy styrene | 5 | 80,000 | 0.35 |
| Ex. 4A | Polymer 3 | hydroquinone tert-butyl ether | 0.7 | 80,000 | 0.35 |
| Ex. 5A | Polymer 3 | tert-butyl 4-hydroxyphenyloxyacetate | 0.7 | 80,000 | 0.35 |

Examples 6A to 10A

Preparation of Resist Compositions

Each of the acid decomposition group-introduced hyperbranched polymers in Examples 1 to 5 in an amount of 10 mass% was mixed with a propylene glycol monomethyl acetate solution containing 0.1 mass% of a photoacid generator (PAG1 to PAG3) according to the combination shown in Table 1A. Thus, resist compositions were prepared in Examples 6 to 10.

Each of the obtained resist compositions was spin-coated on a silicon wafer and subjected to a heat treatment at 90°C for one minute to evaporate the solvent, so that a thin layer with a thickness of 300 nm was formed. Thus, a sample for evaluation was prepared.

<Evaluation Method for Alkali Solubility>

To obtain the solubility in an alkaline aqueous solution, the sample thin layer with a thickness of about 300 nm formed on the silicon wafer was irradiated with electron beams using an electron beam lithography system (CABL 9000, made by CRESTEC Corporation) in such a fashion that electron beams with an intensity of 50 to 5000 mJ/cm$^2$ were applied to a square portion measuring 30 micrometers by 30 micrometers, and thereafter the sample was subjected to a heat treatment at 120°C for 90 seconds. Then, the sample was immersed in an aqueous solution containing 2.4 mass% of tetramethylammonium hydroxide (TMAH) as an alkaline chemical at 25°C for 4 minutes, and subsequently washed with water and dried. The state of the dried thin layer was observed using a digital microscope (VH-6300VH, made by KEYENCE Corporation) and evaluated on the following criteria. The results are shown in Table 2A.

[Evaluation criteria]

○: the state where the light exposed surface bears no portion remaining to be dissolved.
Δ: the state where the light exposed surface bears some portions remaining to be dissolved.
× : the state where the light exposed surface bears a lot of portions remaining to be dissolved.

<Evaluation Method for Surface Roughness>

The surface roughness of the light exposed surface was determined by the method described in Masao NAGASE, *Metrology ofnano-structures using atomic force microscopy and its application to device and process for meas-*

*urement,* Doctoral dissertation of Waseda University 2475, pp.99-107 (1996). Using an electron beam lithography system (CABL 9000, made by CRESTEC Corporation), the measurement of the surface roughness was conducted with respect to a surface irradiated with an exposure corresponding to 30% of the electron beam exposure by which the solubility in an alkaline aqueous solution was exhibited previously. The electron beams were applied to a square portion measuring 30 micrometers by 30 micrometers on the sample thin layer with a thickness of about 300 nm formed on the silicon wafer, and then heat treatment was conducted at 120°C for 90 seconds. Thereafter, the sample was immersed in an aqueous solution containing 2.4 mass% of tetramethylammonium hydroxide (TMAH) at 25°C for 4 minutes, and subsequently washed with water and dried. The dried surface was subjected to evaluation.

Using an atomic force microscopy (SPM-9500J3, made by Shimadzu Corporation), the surface roughness of the sample was determined by measuring a value of ten-point height of irregularities in accordance with JIS B0601-1994 as an index of surface roughness. The results are shown in Table 2A.

Table 2A

| | Hyper-branched Polymer | Acid Decomposition Group-Containing Compound | | Photoacid Generator | Alkali Solubility | Roughness (nm) |
|---|---|---|---|---|---|---|
| | | Name | Added amount (times) | | | |
| Ex. 6A | Polymer 1 | p-tert-butoxy styrene | 0.3 | PAG1 | ○ | 1.0 |
| Ex. 7A | Polymer 2 | p-tert-butoxy styrene | 5 | PAG1 | ○ | 0.8 |
| Ex. 8A | Polymer 3 | p-ethoxy ethoxy styrene | 5 | PAG2 | ○ | 0.9 |
| Ex. 9A | Polymer 3 | hydroquinone tert-butyl ether | 0.7 | PAG3 | ○ | 1.0 |
| Ex. 10A | Polymer 3 | tert-butyl 4-hydroxyphenyloxyacetate | 0.7 | PAG1 | ○ | 1.1 |

Example 1B

Synthesis of Hyperbranched Polymer

In a 50 mL reaction vessel, 21 mmol of chloromethyl styrene as a reactive monomer, and 13.1 mmol of 2,2-bipyridyl and 6.6 mmol of copper (I) chloride as a catalyst were placed together with 8 mL of chlorobenzene as a solvent. After the atmosphere in the reaction vessel was replaced with argon, a polymerization reaction was carried out with stirring at 115°C for 30 minutes. With the addition of 50 mL of tetrahydrofuran to the obtained reaction liquid, the resultant polymer was diluted and dissolved. After that, the reaction mixture was filtered through activated alumina to remove the catalyst. After the obtained filtrate was concentrated, the polymer was precipitated by the addition of 200 mL of methanol and the supernatant fluid was eliminated, thereby removing the unreacted monomers and the reaction solvent. Subsequently, the precipitated polymer was dissolved in 20 mL of tetrahydrofuran, and thereafter reprecipitated two times with the addition of 500 mL of methanol, so that a core portion A was synthesized (in a 60% yield).

Then, 1 g of the core portion A as a starting polymer, 33 mmol of tert-butyl acrylate as an acid decomposition group-containing compound, and 4.1 mmol of 2,2-bipyridyl and 2.1 mmol of copper (I) chloride as a catalyst were placed in a 50 mL reaction vessel together with 13 mL of chlorobenzene as a solvent. After the atmosphere in the reaction vessel was replaced with argon, a polymerization was carried out with stirring at 125°C for 30 minutes. With the addition of 50 mL of tetrahydrofuran to the obtained reaction liquid, the resultant polymer was diluted and dissolved. After that, the reaction mixture was filtered through activated alumina to remove the catalyst. After the obtained filtrate was concentrated, the polymer was precipitated by the addition of 200 mL of methanol and the supernatant fluid was eliminated, thereby removing the unreacted monomers and the reaction solvent. Subsequently, the precipitated polymer was dissolved in 20 mL of tetrahydrofuran, and thereafter reprecipitated two times with the addition of 500 mL of methanol, thereby synthesizing a desired acid decomposition group-introduced hyperbranched polymer <1>, which is represented by the following formula:

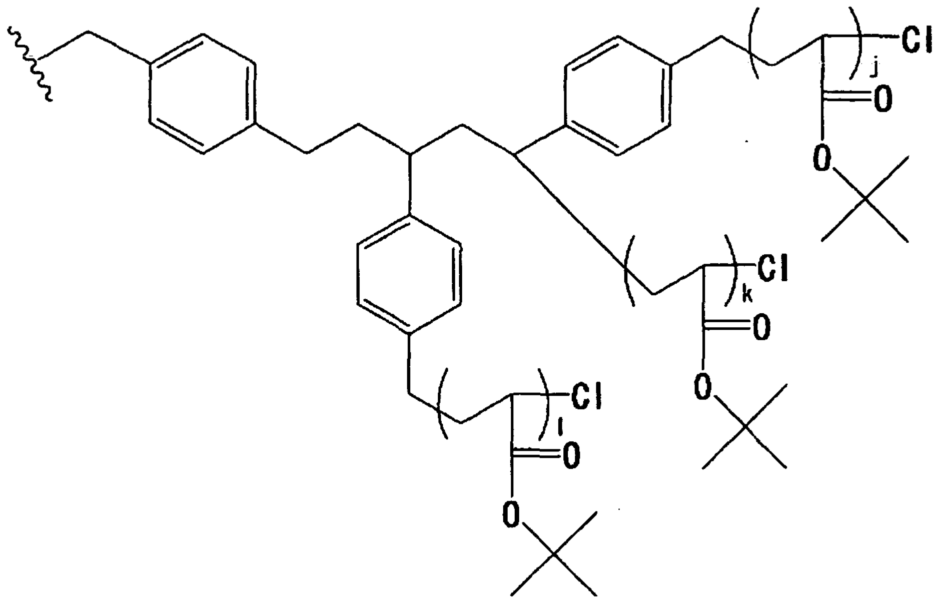

wherein j, k and l are each a number of 1 or more.

The weight average molecular weight (Mw) and the degree of branching (Br) of the obtained core portion A were measured by the methods shown below.

The weight average molecular weight (Mw) of the core portion A was determined by preparing a tetrahydrofuran solution containing 0.05 mass% of the core portion A and subjecting the solution to the measurement of GPC at 40°C. Tetrahydrofuran was used as a solvent for the mobile phase, and styrene was used as a reference material. The degree of branching of the core portion A was obtained by calculating in accordance with the equation (A) previously mentioned. The results are shown in Table 1B.

Further, the weight average molecular weight (Mw) of the hyperbranched polymer <1> was obtained in the same manner as in the measurement of the Mw of the core portion A. The introduction ratio of the acid decomposition group was obtained by calculating in accordance with the equation (a) mentioned above. The results are shown in Table 1B.

Preparation of Resist Composition

A propylene glycol monomethyl acetate solution containing 10 mass% of the acid decomposition group-introduced hyperbranched polymer <1> and 0.5 mass% of triphenyl sulfonium trifluoromethanesulfonate as a photoacid generator was prepared. The resultant solution was filtered through a filter of 0.45 μm, so that a resist composition was prepared.

The obtained resist composition was spin-coated on a silicon wafer and subjected to a heat treatment at 90°C for one minute to evaporate the solvent, so that a thin layer with a thickness of 300 nm was formed, which was used as a sample for evaluation.

<Evaluation Method for Alkali Solubility>

To obtain the solubility in an alkaline aqueous solution, the sample thin layer with a thickness of about 300 nm formed on the silicon wafer was irradiated with electron beams using an electron beam lithography system (CABL 9000, made by CRESTEC Corporation) in such a fashion that electron beams with an intensity of 50 to 5000 mJ/cm$^2$ were applied to a rectangle portion measuring 3 micrometers by 50 micrometers, and thereafter the sample was subjected to a heat treatment at 100°C for 4 minutes. Then, the sample was immersed in an aqueous solution containing 2.4 mass% of tetramethylammonium hydroxide (TMAH) as an alkaline chemical at 25°C for 2 minutes, and subsequently washed with water and dried. The state of the dried thin layer was observed using a digital microscope (VH-6300VH, made by KEYENCE Corporation) and evaluated on the following criteria. The results are shown in Table 2B.

[Evaluation criteria]

◎: the state where the light exposed surface bears no portion remaining to be dissolved, and the edge is vertical.
◎-○: the state where the light exposed surface bears no portion remaining to be dissolved, and the edge slants slightly.
○: the state where the light exposed surface bears substantially no portion remaining to be dissolved.
×: the state where portions remaining to be dissolved are observed.

<Evaluation Method for Surface Roughness>

The surface roughness of the light exposed surface was determined by the method described in Masao NAGASE, *Metrology of nano-structures using atomic force microscopy and its application to device and process for measurement,* Doctoral dissertation of Waseda University 2475, pp.99-107, (1996). Using an electron beam lithography system (CABL 9000, made by CRESTEC Corporation), the measurement of the surface roughness was conducted with respect to a surface irradiated with an exposure corresponding to 30% of the electron beam exposure by which the solubility in an alkaline aqueous solution was exhibited previously. The electron beams were applied to a square portion measuring 30 micrometers by 30 micrometers on the sample thin layer with a thickness of about 300 nm formed on the silicon wafer, and then heat treatment was conducted at 100°C for 4 minutes. Thereafter, the sample was immersed in an aqueous solution containing 2.4 mass% of tetramethylammonium hydroxide (TMAH) at 25°C for 2 minutes, and subsequently washed with water and dried. The dried surface was subjected to evaluation.

Using an atomic force microscopy (SPM-9500J3, made by Shimadzu Corporation), the surface roughness of the sample was determined by measuring a value of ten-point height of irregularities in accordance with JIS B0601-1994 as an index of surface roughness. The results are shown in Table 2B.

Example 2B

Synthesis of Hyperbranched Polymer

The same procedure as in Example 1B was repeated except that the amount of catalyst (2,2-bipyridyl and copper (I) chloride) were increased by 0.8 times and the reaction temperature was changed to 125°C to carry out the polymerization in the above-mentioned step of synthesizing the core portion in a molecule of hyperbranched polymer, so that a core portion B was synthesized (in a 77% yield). The weight average molecular weight (Mw) and the degree of branching (Br) of the obtained core portion B were measured in the same manner as in Example 1B. The results are shown in Table 1B.

The same procedure as in Example 1B was repeated except that 1 g of the core portion B was used as the starting polymer, the amount of catalyst (2,2-bipyridyl and copper (I) chloride) were increased by 0.8 times, and the reaction time was changed to 3 hours to carry out the polymerization in the above-mentioned step of introducing the acid decomposition group. Thus, a hyperbranched polymer <2> was synthesized.

The weight average molecular weight (Mw) of the obtained acid decomposition group-introduced hyperbranched polymer <2> was determined in the same manner as in Example 1B. The introduction ratio of the acid decomposition group with respect to the number of constituent monomers having formula 1 of the core portion was determined by calculating in accordance with the equation (a). The results are shown in Table 1B.

Preparation of Resist Composition

A resist composition was obtained in the same manner as in Example 1B except that the acid decomposition group-introduced hyperbranched polymer <2> was employed.

The alkali solubility and the surface roughness were evaluated in the same manner as in Example 1B. The results are shown in Table 2B.

Example 3B

Synthesis of Hyperbranched Polymer

The same procedure as in Example 1B was repeated except that the polymerization was carried out at a reaction temperature of 125°C in the above-mentioned step of synthesizing the core portion in a molecule of the hyperbranched polymer, so that a core portion C was synthesized (in a 78% yield). The weight average molecular weight

(Mw) and the degree of branching (Br) of the obtained core portion C were measured in the same manner as in Example 1B. The results are shown in Table 1B.

The same procedure as in Example 1B was repeated except that 1 g of the core portion C was used as the starting polymer and the reaction time for polymerization was changed to 3 hours in the above-mentioned step of introducing the acid decomposition group. Thus, a hyperbranched polymer <3> was synthesized.

Further, the weight average molecular weight (Mw) of the obtained acid decomposition group-introduced hyperbranched polymer <3> was determined in the same manner as in Example 1B, and the introduction ratio of the acid decomposition group with respect to the number of constituent monomers having formula 1 of the core portion was determined by calculating in accordance with the equation (a). The results are shown in Table 1B.

Preparation of Resist Composition

A resist composition was obtained in the same manner as in Example 1B except that the acid decomposition group-introduced hyperbranched polymer <3> was employed. After that, a sample for evaluation was prepared.

The alkali solubility and the surface roughness were evaluated in the same manner as in Example 1B. The results are shown in Table 2B.

Example 4B

The same procedure as in Example 2B was repeated except that the polymerization was carried out using 1 g of the core portion B synthesized in Example 2B as the starting polymer and 33 mmol of tert-butyl methacrylate as an acid decomposition group-containing compound in the step of introducing the acid decomposition group, so that a desired hyperbranched polymer <4> was synthesized, which is represented by the formula shown below.

The weight average molecular weight (Mw) of the obtained acid decomposition group-introduced hyperbranched polymer <4> was determined in the same manner as in Example 1B, and the introduction ratio of the acid decomposition group with respect to the number of constituent monomers having formula 1 of the core portion was determined by calculating in accordance with the equation (a). The results are shown in Table 1B.

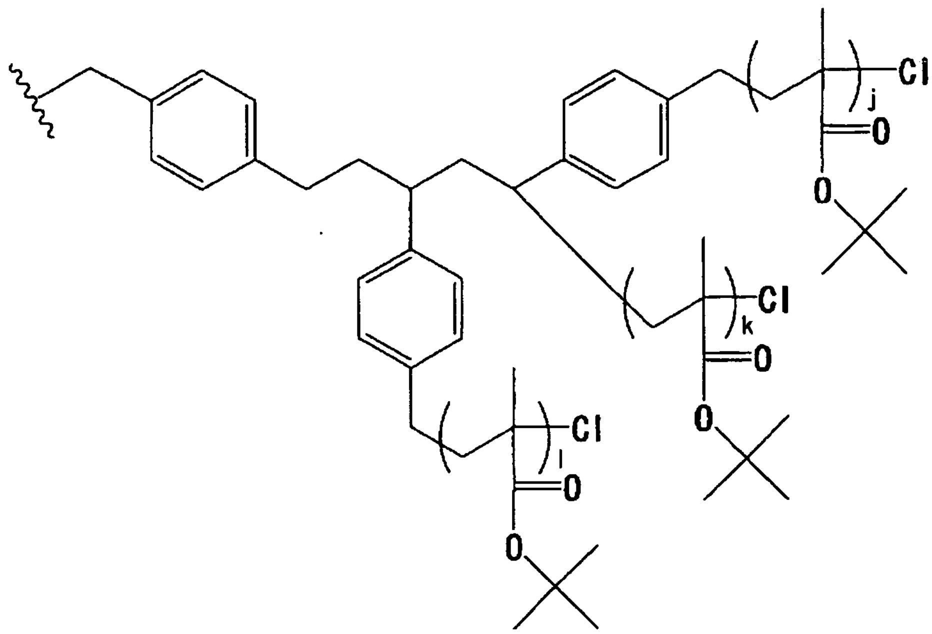

wherein j, k and 1 are each a number of 1 or more.

Preparation of Resist Composition

A resist composition was obtained in the same manner as in Example 1B except that the acid decomposition group-introduced hyperbranched polymer <4> was employed.

The alkali solubility and the surface roughness were evaluated in the same manner as in Example 1B. The

results are shown in Table 2B.

Example 5B

The same procedure as in Example 2B was repeated except that the polymerization was carried out using 1 g of the core portion B synthesized in Example 2B as the starting polymer and 33 mmol of tert-butoxy styrene as an acid decomposition group-containing compound in the step of introducing the acid decomposition group, so that a desired hyperbranched polymer <5> was synthesized, which is represented by the formula shown below.
The weight average molecular weight (Mw) of the obtained acid decomposition group-introduced hyperbranched polymer <5> was determined in the same manner as in Example 1B, and the introduction ratio of the acid decomposition group with respect to the number of constituent monomers having formula 1 of the core portion was determined by calculating in accordance with the equation (a). The results are shown in Table 1B.

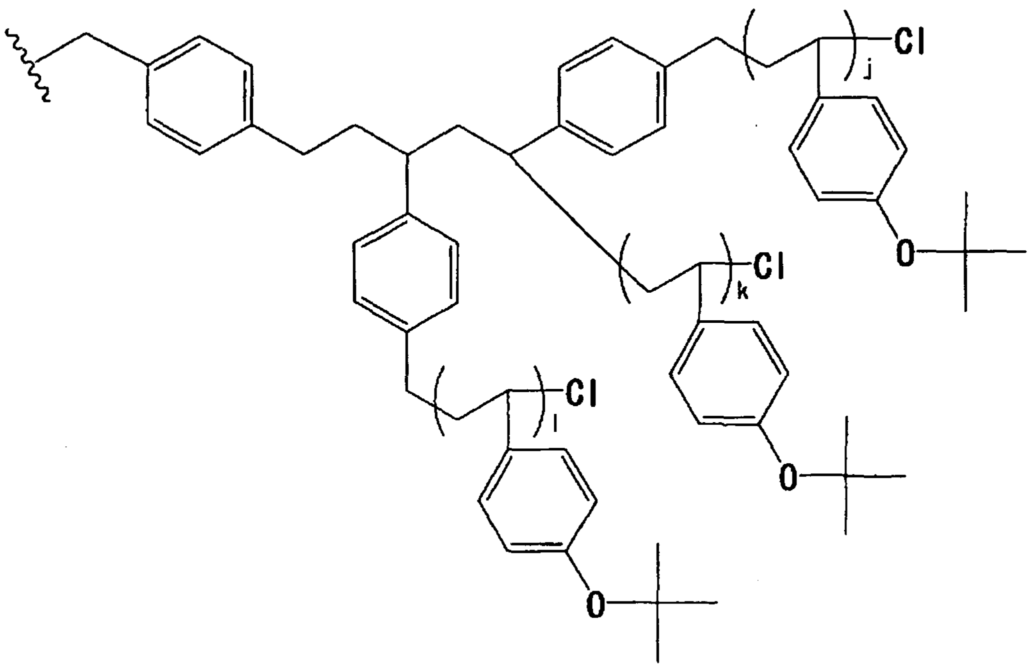

wherein j, k and 1 are each a number of 1 or more.

Preparation of Resist Composition

A resist composition was obtained in the same manner as in Example 1B except that the acid decomposition group-introduced hyperbranched polymer <5> was employed.
The alkali solubility and the surface roughness were evaluated in the same manner as in Example 1B. The results are shown in Table 2B.

Example 6B

Synthesis of Hyperbranched Polymer

The same procedure as in Example 2B was repeated except that the polymerization was carried out using 1 g of the core portion B synthesized in Example 2B as the starting polymer and 33 mmol of a monomer having formula (15) as an acid decomposition group-containing compound in the step of introducing the acid decomposition group, so that a desired hyperbranched polymer <6> was synthesized, which is represented by the formula shown below.
The weight average molecular weight (Mw) of the obtained acid decomposition group-introduced hyperbranched polymer <6> was determined in the same manner as in Example 1B, and the introduction ratio of the acid decomposition group with respect to the number of constituent monomers having formula 1 of the core portion was determined by

calculating in accordance with the equation (a). The results are shown in Table 1B.

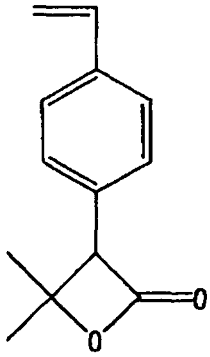

(1 5)

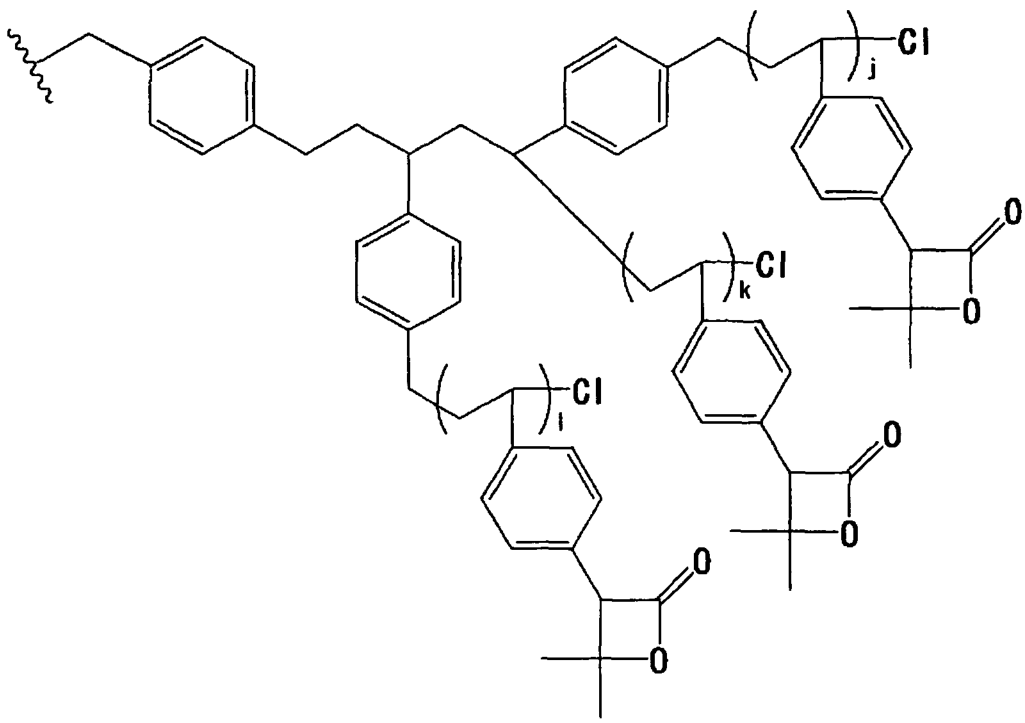

wherein j, k and 1 are each a number of 1 or more.

Preparation of Resist Composition

A resist composition was obtained in the same manner as in Example 1B except that the acid decomposition group-introduced hyperbranched polymer <6> was employed.

The alkali solubility and the surface roughness were evaluated in the same manner as in Example 1B. The results are shown in Table 2B.

Example 7B

Synthesis of Hyperbranched Polymer

The same procedure as in Example 2B was repeated except that the polymerization was carried out using 1 g of the core portion B synthesized in Example 2B as the starting polymer and 33 mmol of a monomer having formula (16) as an acid decomposition group-containing compound in the step of introducing the acid decomposition group, so that a desired hyperbranched polymer <7> was synthesized, which is represented by the formula shown below.

The weight average molecular weight (Mw) of the obtained acid decomposition group-introduced hyperbranched polymer <7> was determined in the same manner as in Example 1B, and the introduction ratio of the acid decomposition group with respect to the number of constituent monomers having formula 1 of the core portion was determined by calculating in accordance with the equation (a). The results are shown in Table 1B.

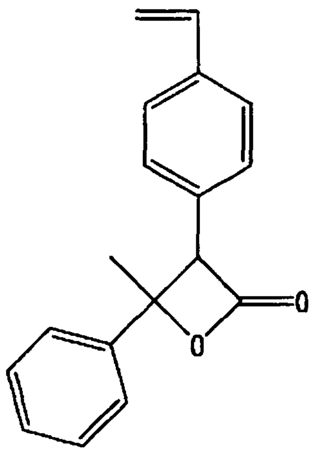

(1 6)

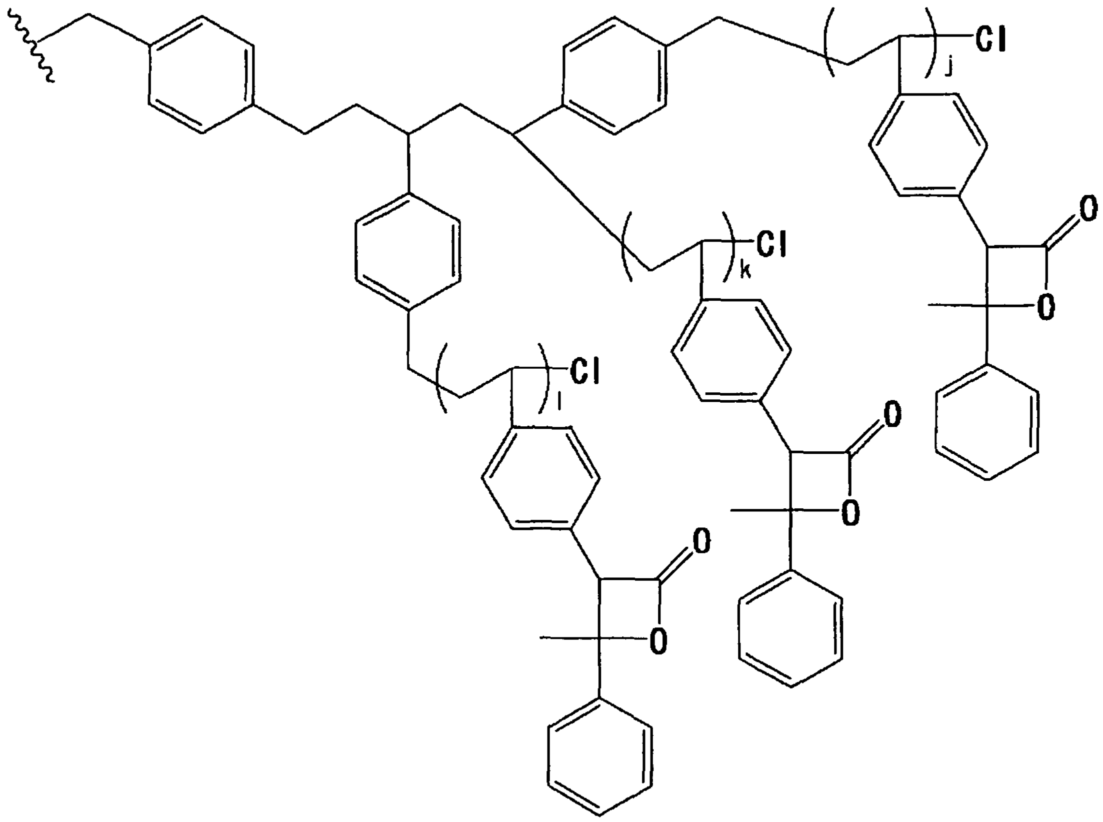

wherein j, k and l are each a number of 1 or more.

Preparation of Resist Composition

A resist composition was obtained in the same manner as in Example 1B except that the acid decomposition group-introduced hyperbranched polymer <7> was employed.

The alkali solubility and the surface roughness were evaluated in the same manner as in Example 1B. The results are shown in Table 2B.

Example 8B

Synthesis of Hyperbranched Polymer

The same procedure as in Example 2B was repeated except that the polymerization was carried out using 1 g of the core portion B synthesized in Example 2B as the starting polymer and 33 mmol of a monomer having formula (17) as an acid decomposition group-containing compound in the step of introducing the acid decomposition group, so that a desired hyperbranched polymer <8> was synthesized, which is represented by the formula shown below.

The weight average molecular weight (Mw) of the obtained acid decomposition group-introduced hyperbranched polymer <8> was determined in the same manner as in Example 1B, and the introduction ratio of the acid decomposition group with respect to the number of constituent monomers having formula 1 of the core portion was determined by calculating in accordance with the equation (a). The results are shown in Table 1B.

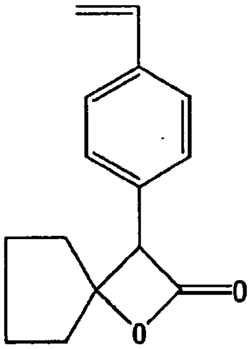

(17)

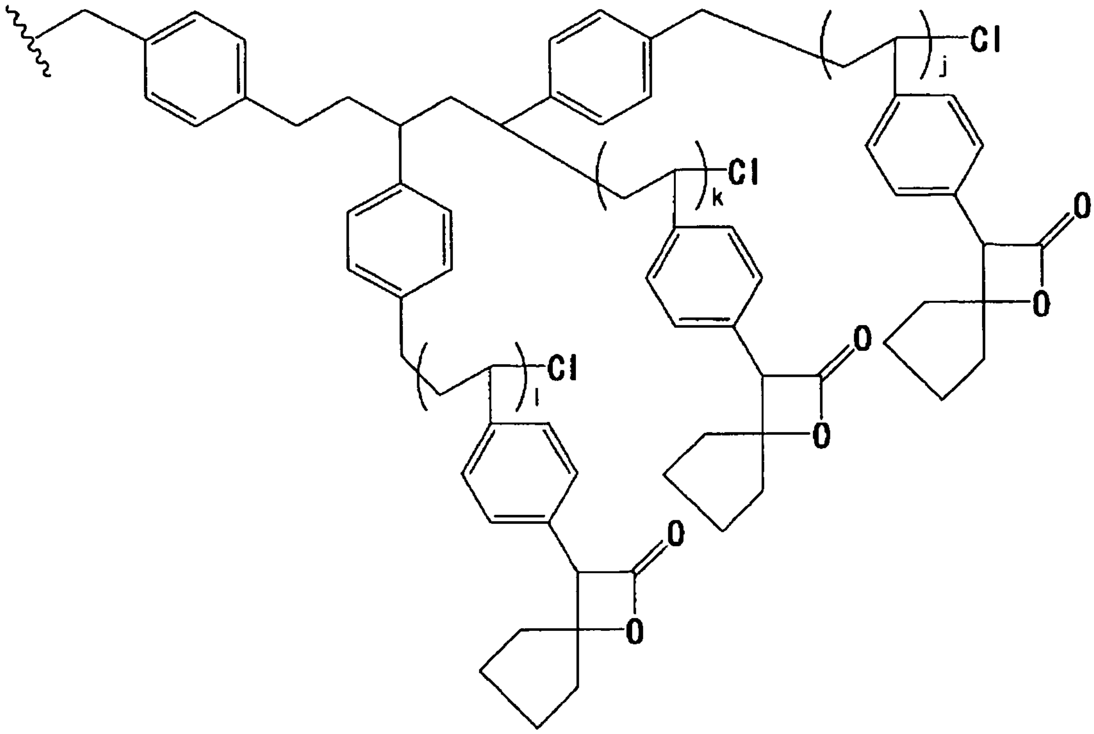

wherein j, k and l are each a number of 1 or more.

Preparation of Resist Composition

A resist composition was obtained in the same manner as in Example 1B except that the acid decomposition group-introduced hyperbranched polymer <8> was employed.

The alkali solubility and the surface roughness were evaluated in the same manner as in Example 1B. The results are shown in Table 2B.

Example 9B

Synthesis of Hyperbranched Polymer

The same procedure as in Example 2B was repeated except that the polymerization was carried out using 1 g of the core portion B synthesized in Example 2B as the starting polymer, and 18 mmol of tert-butyl acrylate and 18 mmol of a monomer having formula (15) as acid decomposition group-containing compounds in the step of introducing the acid decomposition group, so that a desired hyperbranched polymer <9> was synthesized, which is represented by the formula shown below.

The weight average molecular weight (Mw) of the obtained acid decomposition groups-introduced hyperbranched polymer <9 > was determined in the same manner as in Example 1B, and the introduction ratio of the acid decomposition groups with respect to the number of constituent monomers having formula 1 of the core portion was determined by calculating in accordance with the equation (a). The results are shown in Table 1B.

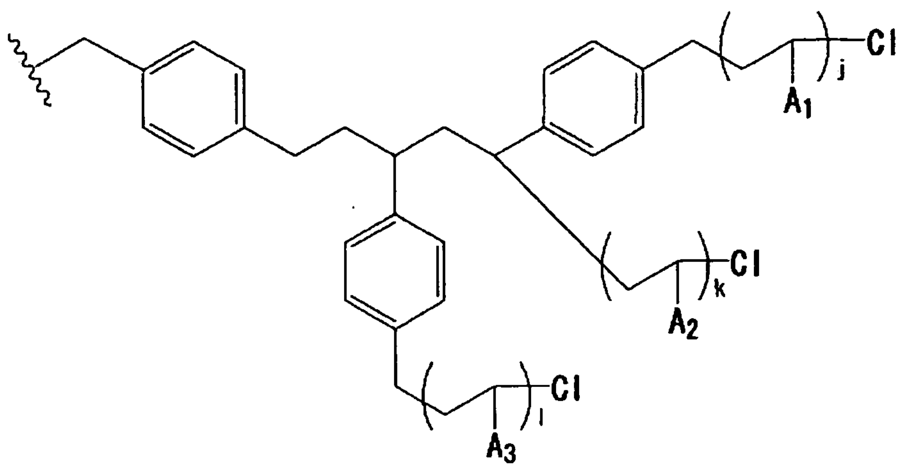

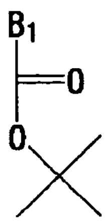

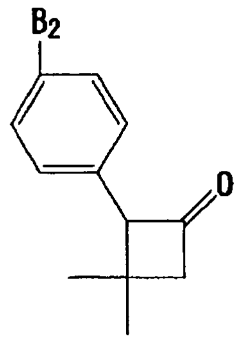

wherein $A_1$, $A_2$ and $A_3$ moieties are bound to link to either Bi or $B_2$ moiety of the above-mentioned acid decomposition groups; and j, k and l are each a number of 1 or more.

Preparation of Resist Composition

A resist composition was obtained in the same manner as in Example 1B except that the acid decomposition groups-introduced hyperbranched polymer <9> was employed.

The alkali solubility and the surface roughness were evaluated in the same manner as in Example 1B. The results are shown in Table 2B.

Example 10B

Synthesis of Hyperbranched Polymer

In a 50 mL reaction vessel, 1 g of the core portion B as a starting polymer, 13.0 mmol of hydroquinone tert-butyl ether as an acid decomposition group-containing compound, and 13.0 mmol of NaH were placed. With the addition of 30 mL of tetrahydrofuran as a solvent, a polymerization reaction was carried out under reflux at 70°C for 5 hours. After the addition of 200 mL of methanol to the reaction product, the precipitated polymer was separated by decantation, washed with water and then dried. Thus, a desired acid decomposition group-introduced hyperbranched polymer <10> was synthesized, which is represented by the following formula:

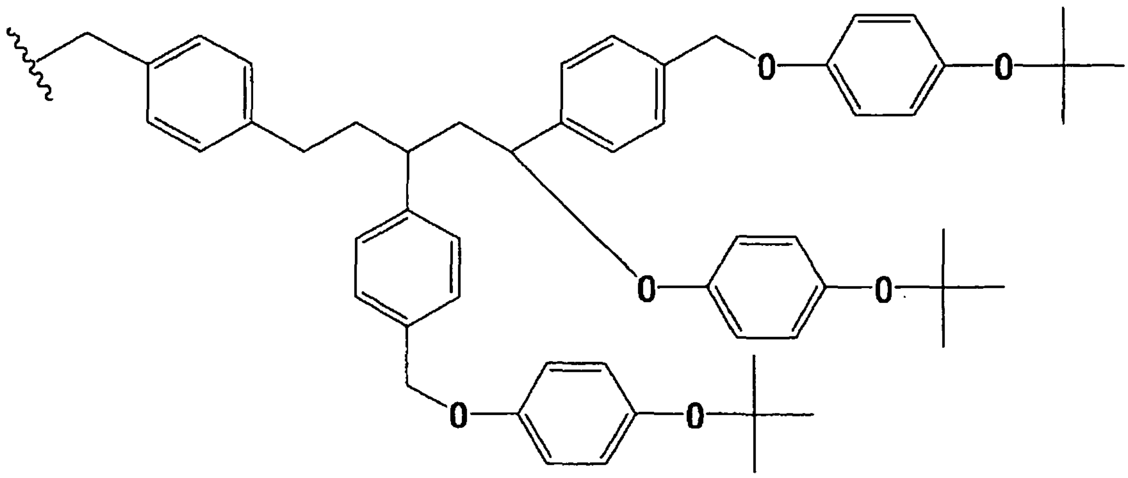

The weight average molecular weight (Mw) of the obtained acid decomposition group-introduced hyperbranched polymer <10> was determined in the same manner as in Example 1B, and the introduction ratio of the acid decomposition group with respect to the number of constituent monomers having formula 1 of the core portion was determined by calculating in accordance with the equation (b). The results are shown in Table 1B.

Preparation of Resist Composition

A resist composition was obtained in the same manner as in Example 1B except that the acid decomposition group-introduced hyperbranched polymer <10> was employed.

The alkali solubility and the surface roughness were evaluated in the same manner as in Example 1B. The results are shown in Table 2B.

Example 11B

Synthesis of Hyperbranched Polymer

The same procedure as in Example 10B was repeated except that 65 mmol of tert-butyl 4-hydroxyphenyloxyacetate was used as an acid decomposition group-containing compound and the reaction time was changed to 3 hours to carry out the polymerization with tert-butyl 4-hydroxyphenyloxyacetate and the subsequent purification in the above-mentioned step of introducing the acid decomposition group. Thus, a desired acid decomposition group-introduced hyperbranched polymer <11> was synthesized, which is represented by the following formula:

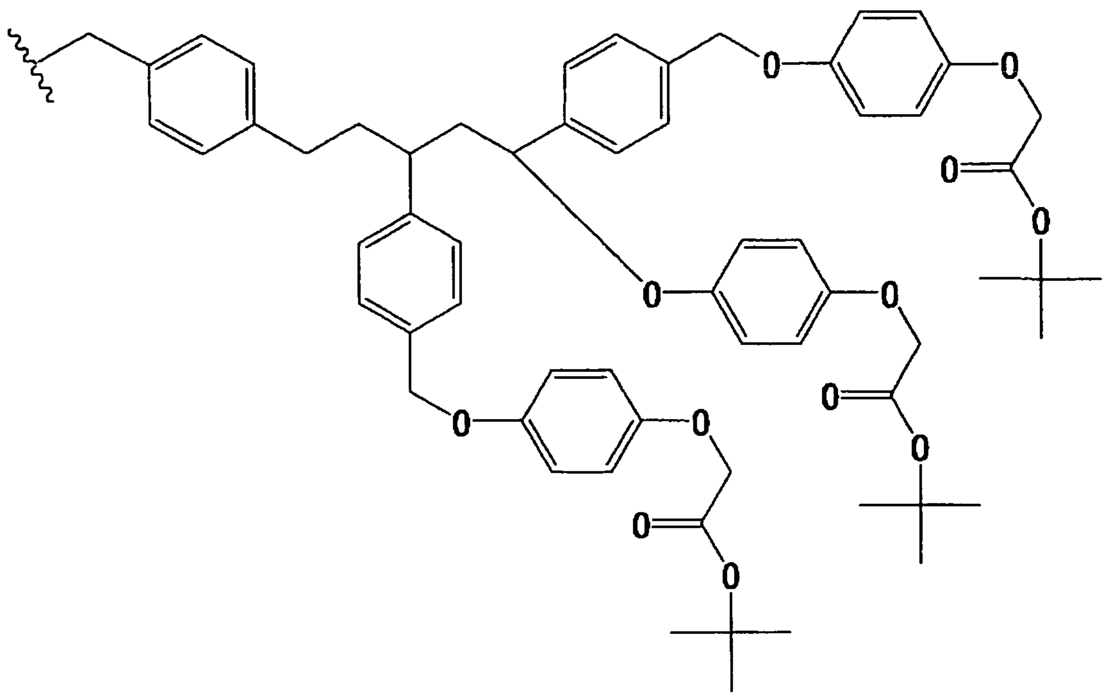

The weight average molecular weight (Mw) of the obtained acid decomposition group-introduced hyperbranched polymer <10> was determined in the same manner as in Example 1B, and the introduction ratio of the acid decomposition group with respect to the number of constituent monomers having formula 1 of the core portion was determined by calculating in accordance with the equation (b). The results are shown in Table 1B.

Preparation of Resist Composition

A resist composition was obtained in the same manner as in Example 1B except that the acid decomposition group-introduced hyperbranched polymer <11> was employed.

The alkali solubility and the surface roughness were evaluated in the same manner as in Example 1B. The results are shown in Table 2B.

Example 12B

Synthesis of Hyperbranched Polymer

In a 50 mL reaction vessel, 1 g of the hyperbranched polymer <2> synthesized in Example 2B as a starting polymer, 4.1 mmol of 2,2-bipyridyl, 2.1 mmol of copper (I) chloride, and 6.3 mmol of tri-n-butyl tin hydride were placed together with 13 ml of chlorobenzene as a solvent, to carry out a reaction with stirring at 60°C for 24 hours. After completing the processes of filtration and purification by precipitation in the same manner as in Example 1B, a desired hyperbranched polymer <12> was synthesized, which is represented by the following formula.

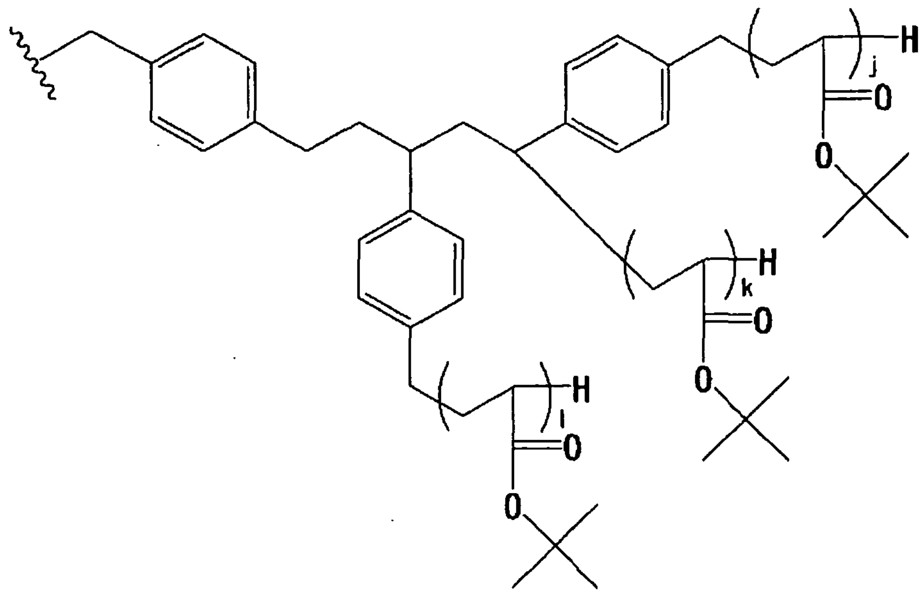

wherein j, k and 1 are each a number of 1 or more.

The weight average molecular weight (Mw) of the dehalogenated hyperbranched polymer <12> was determined in the same manner as in Example 1B. The results are shown in Table 1B.

Example 13B

Synthesis of Hyperbranched Polymer

In a 50 mL reaction vessel, 21 mmol of chloromethyl styrene as a reactive monomer, and 10.5 mmol of 2,2-bipyridyl and 5.3 mmol of copper (I) chloride as a catalyst were placed together with 8 mL of chlorobenzene as a solvent. After the atmosphere in the reaction vessel was replaced with argon, a polymerization reaction was carried out with stirring at 125°C for 30 minutes.

Without the subsequent purification, a mixture of 105 mmol of tert-butyl acrylate as an acid decomposition group-containing compound and 32 mL of chlorobenzene as a solvent was added dropwise to the above-mentioned reaction vessel, to carry out a polymerization with stirring at 125°C for 30 minutes. With the addition of 50 mL of tetrahydrofuran to the obtained reaction liquid, the resultant polymer was diluted and dissolved. After that, the reaction mixture was filtered through activated alumina to remove the catalyst. After the obtained filtrate was concentrated, the polymer was precipitated by the addition of 200 mL of methanol and the supernatant fluid was eliminated, thereby removing the unreacted monomers and the reaction solvent. Subsequently, the precipitated polymer was dissolved in 20 mL of tetrahydrofuran, and thereafter reprecipitated two times with the addition of 500 mL of methanol, so that a desired acid decomposition group-introduced hyperbranched polymer <13> was synthesized.

The above is the case where the step of synthesizing the core portion in a molecule of the hyperbranched polymer and the step of introducing the acid decomposition group are successively carried out.

The weight average molecular weight (Mw) of the obtained acid decomposition group-introduced hyperbranched polymer <13> was determined in the same manner as in Example 1B. Further, to obtain the amount of added acid decomposition group, the integral value for a proton characteristic of the acid decomposition group was obtained from $^1$H-NMR of the product and the ratio with respect to the number of styrene derivatives as the constituent units of the core portion was calculated. The results are shown in Table 1B.

Preparation of Resist Composition

A resist composition was obtained in the same manner as in Example 1B except that the acid decomposition group-introduced hyperbranched polymer <13> was employed.

The alkali solubility and the surface roughness were evaluated in the same manner as in Example 1B. The results are shown in Table 2B.

Example 14B

Synthesis of Hyperbranched Polymer

The same procedure as in Example 2B was repeated except that the polymerization was carried out using 18 mmol of chloromethyl styrene and 2 mmol of styrene as the reactive monomers in the above-mentioned step of synthesizing the core portion in a molecule of hyperbranched polymer, so that a core portion D was synthesized (in a 76% yield). The weight average molecular weight (Mw) of the obtained core portion D was measured in the same manner as in Example 1B. The results are shown in Table 1B.

Subsequently, the same procedure as in Example 2B was repeated except that 1 g of the core portion D was used for the polymerization as the starting polymer in the above-mentioned step of introducing the acid decomposition group. Thus, a hyperbranched polymer <14> was synthesized.

The weight average molecular weight (Mw) of the obtained acid decomposition group-introduced hyperbranched polymer <14> was determined in the same manner as in Example 1B. The introduction ratio of the acid decomposition group with respect to the number of constituent monomers having formula 1 of the core portion was determined by calculating in accordance with the equation (c) previously mentioned. The results are shown in Table 1B.

Preparation of Resist Composition

A resist composition was obtained in the same manner as in Example 1B except that the acid decomposition group-introduced hyperbranched polymer <14> was employed.

The alkali solubility and the surface roughness were evaluated in the same manner as in Example 1B. The results are shown in Table 2B.

Example 15B

Synthesis of Hyperbranched Polymer

The same procedure as in Example 2B was repeated except that the polymerization was carried out using 18 mmol of chloromethyl styrene and 2 mmol of tert-butyl acrylate as the reactive monomers in the above-mentioned step of synthesizing the core portion in a molecule of hyperbranched polymer, so that a core portion E was synthesized (in a 77% yield). The above-mentioned tert-butyl acrylate was also used as an acid decomposition group. The weight average molecular weight (Mw) of the obtained core portion E was measured in the same manner as in Example 1B. The results are shown in Table 1B.

Subsequently, the same procedure as in Example 2B was repeated except that 1 g of the core portion E was used for the polymerization as the starting polymer in the above-mentioned step of introducing the acid decomposition group. Thus, a hyperbranched polymer <15> was synthesized.

The weight average molecular weight (Mw) of the obtained acid decomposition group-introduced hyperbranched polymer <15> was determined in the same manner as in Example 1B. The introduction ratio of the acid decomposition group with respect to the number of constituent monomers having formula 1 of the core portion was determined by calculating in accordance with the equation (c). The results are shown in Table 1B.

Preparation of Resist Composition

A resist composition was obtained in the same manner as in Example 1B except that the acid decomposition group-introduced hyperbranched polymer <15> was employed.

The alkali solubility and the surface roughness were evaluated in the same manner as in Example 1B. The results are shown in Table 2B.

Example 16B

Synthesis of Hyperbranched Polymer

The same procedure as in Example 2B was repeated except that the polymerization was carried out using 16 mmol of chloromethyl styrene, 2 mmol of styrene and 2 mmol of tert-butoxy styrene as the reactive monomers in the above-mentioned step of synthesizing the core portion in a molecule of hyperbranched polymer, so that a core portion F was synthesized (in a 80% yield). The above-mentioned tert-butoxy styrene was also used as an acid decomposition group. The weight average molecular weight (Mw) of the obtained core portion F was measured in the same manner

as in Example 1B. The results are shown in Table 1B.

Subsequently, the same procedure as in Example 2B was repeated except that 1 g of the core portion F was used for the polymerization as the starting polymer in the above-mentioned step of introducing the acid decomposition group. Thus, a hyperbranched polymer <16> was synthesized.

The weight average molecular weight (Mw) of the obtained acid decomposition group-introduced hyperbranched polymer <16> was determined in the same manner as in Example 1B. The introduction ratio of the acid decomposition group with respect to the number of constituent monomers having formula 1 of the core portion was determined by calculating in accordance with the equation (c). The results are shown in Table 1B.

Preparation of Resist Composition

A resist composition was obtained in the same manner as in Example 1B except that the acid decomposition group-introduced hyperbranched polymer <16> was employed.

The alkali solubility and the surface roughness were evaluated in the same manner as in Example 1B. The results are shown in Table 2B.

Example 17B

Synthesis of Hyperbranched Polymer

The same procedure as in Example 2B was repeated except that the polymerization was carried out using 1 g of the core portion D synthesized in Example 14B as the starting polymer and 33 mmol of tert-butoxy styrene as the acid decomposition group-containing compound in the above-mentioned step of introducing the acid decomposition group. Thus, a hyperbranched polymer <17> was synthesized.

The weight average molecular weight (Mw) of the obtained acid decomposition group-introduced hyperbranched polymer <17> was determined in the same manner as in Example 1B. The introduction ratio of the acid decomposition group with respect to the number of constituent monomers having formula 1 of the core portion was determined by calculating in accordance with the equation (c). The results are shown in Table 1B.

Preparation of Resist Composition

A resist composition was obtained in the same manner as in Example 1B except that the acid decomposition group-introduced hyperbranched polymer <17> was employed.

The alkali solubility and the surface roughness were evaluated in the same manner as in Example 1B. The results are shown in Table 2B.

Example 18B

Synthesis of Hyperbranched Polymer

The same procedure as in Example 2B was repeated except that the polymerization was carried out using 1 g of the core portion E synthesized in Example 15B as the starting polymer and 33 mmol of tert-butoxy styrene as the acid decomposition group-containing compound in the above-mentioned step of introducing the acid decomposition group. Thus, a hyperbranched polymer <18> was synthesized.

The weight average molecular weight (Mw) of the obtained acid decomposition group-introduced hyperbranched polymer <18> was determined in the same manner as in Example 1B. The introduction ratio of the acid decomposition group with respect to the number of constituent monomers having formula 1 of the core portion was determined by calculating in accordance with the equation (c). The results are shown in Table 1B.

Preparation of Resist Composition

A resist composition was obtained in the same manner as in Example 1B except that the acid decomposition group-introduced hyperbranched polymer <18> was employed.

The alkali solubility and the surface roughness were evaluated in the same manner as in Example 1B. The results are shown in Table 2B.

Example 19B

Synthesis of Hyperbranched Polymer

The same procedure as in Example 2B was repeated except that the polymerization was carried out using 1 g of the core portion F synthesized in Example 16B as the starting polymer and 33 mmol of tert-butoxy styrene as the acid decomposition group-containing compound in the above-mentioned step of introducing the acid decomposition group. Thus, a hyperbranched polymer <19> was synthesized, which is represented by the formula shown below.

The weight average molecular weight (Mw) of the obtained acid decomposition group-introduced hyperbranched polymer <19> was determined in the same manner as in Example 1B. The introduction ratio of the acid decomposition group with respect to the number of constituent monomers having formula 1 of the core portion was determined by calculating in accordance with the equation (c). The results are shown in Table 1B.

Preparation of Resist Composition

A resist composition was obtained in the same manner as in Example 1B except that the acid decomposition group-introduced hyperbranched polymer <19> was employed.

The alkali solubility and the surface roughness were evaluated in the same manner as in Example 1B. The results are shown in Table 2B.

Example 20B

Preparation of Resist Composition

A resist composition was obtained in the same manner as in Example 1B except that 10 mass% of the acid decomposition group-introduced hyperbranched polymer <2> and 0.5 mass% of bis(tert-butylsulfonyl)diazomethane as a photoacid generator were employed.

The alkali solubility and the surface roughness were evaluated in the same manner as in Example 1B. The results are shown in Table 2B.

Table 1B

| Example | Core Portion of Molecule | | | |
|---|---|---|---|---|
| | Type | Monomer(s) for constituting core portion of molecule | Weight average molecular weight (Mw) | Degree of branching (Br |
| 1B | A | CMS | 3,000 | 0.41 |
| 2B | B | CMS | 10,0 | |
| 3B | C | CMS | | |
| 4B | B | CMS | | |
| 5B | B | CMS | | |
| 6B | B | CMS | | |
| 7B | B | CMS | | |
| 8B | B | CMS | | |
| 9B | B | CMS | | |
| 10B | B | CMS | | |
| 11B | B | CMS | | |
| 12B | B | CMS | | |
| 13B | --- | CMS | | |
| 14B | D | CMS/styrene | | |
| 15B | E | CMS/tert-Ba | | |

(continued)

| Example | Core Portion of Molecule | | | |
|---|---|---|---|---|
| | Type | Monomer(s) for constituting core portion of molecule | Weight average molecular weight (Mw) | Degree of branching (Br |
| 16B | F | CMS/styrene/tert-butoxy styrene | | |
| 17B | D | CMS/styrene | | |
| 18B | E | CMS/tert-BA | | |
| 19B | F | CMS/styrene/tert-butoxy styrene | | |
| Ex. | Hyperbranched Polymer | | | |
| | No. | Acid decomposition group-containing compound | Weight average molecular weight (Mw) | Molar ratio of introduced acid decomposition groupe |
| 1B | <1> | tert-BA | 6,000 | 1.2 |
| 2B | <2> | tert-BA | 23,000 | 1.5 |
| 3B | <3> | tert-BA | 50,000 | 0.8 |
| 4B | <4> | tert-butyl methacrylate | 25,000 | 1.6 |
| 5B | <5> | tert-butoxy styrene | 27,000 | 1.5 |
| 6B | <6> | structural formula (15) | 24,000 | 1.1 |
| 7B | <7> | structural formula (16) | 26,000 | 0.9 |
| 8B | <8> | structural formula (17) | 28,000 | 1.2 |
| 9B | <9> | tert-BA/structural formula (15) | 25,000 | 1.4 |
| 10B | <10> | hydroquinone-tert-butyl ether | 16,000 | 0.7 |
| 11B | <11> | tert-butyl 4-hydroxyphenyloxy acetate | 20,000 | 0.8 |
| 12B | <12> | tert-BA | 21,000 | 1.5 |
| 13B | <13> | tert-BA | 23,000 | 1.5 |
| 14B | <14> | tert-BA | 22,000 | 1.9 |
| 15B | <15> | tert-BA | 21,000 | 1.8 |
| 16B | <16> | tert-BA | 21,000 | 2.0 |
| 17B | <17> | tert-butoxy styrene | 26,000 | 1.8 |
| 18B | <18> | tert-butoxy styrene | 24,000 | 1.7 |
| 19B | <19> | tert-butoxy styrene | 23,000 | 1.8 |

Table 2B

| Ex. | Hyperbranched Polymer | | | | Photoacid Generator | Alkali Solubility | Surface Roughness (nm) |
|---|---|---|---|---|---|---|---|
| | No. | Acid decomposition group-containing compound | Weight average molecular weight (Mw) | Molar ratio of introduced acid decomposition group | | | |
| 1B | <1> | tert-BA | 6,000 | 1.2 | TPST | ◎ | 1.4 |
| 2B | <2> | tert-BA | 23,000 | 1.5 | TPST | ◎ | 1.0 |
| 3B | <3> | tert-BA | 50,000 | 0.8 | TPST | ◎~○ | 1.8 |
| 4B | <4> | tert-butyl methacrylate | 25,000 | 1.6 | TPST | ◎ | 1.0 |
| 5B | <5> | tert-butoxy styrene | 27,000 | 1.5 | TPST | ○ | 1.8 |
| 6B | <6> | structural formula (15) | 24,000 | 1.1 | TPST | ◎~○ | 1.2 |
| 7B | <7> | structural formula (16) | 26,000 | 0.9 | TPST | ◎~○ | 1.3 |
| 8B | <8> | structural formula (17) | 28,000 | 1.2 | TPST | ◎~○ | 1.1 |
| 9B | <9> | tert-BA/ structural formula (15) | 25,000 | 1.4 | TPST | ◎ | 1.1 |
| 10B | <10> | hydroquinone -tert-butyl ether | 16,000 | 0.7 | TPST | ◎~○ | 1.5 |
| 11B | <11> | tert-butyl 4-hydroxy phenyloxy acetate | 20,000 | 0.8 | TPST | ◎~○ | 1.2 |
| 12B | <12> | tert-BA | 21,000 | 1.5 | TPST | ◎ | 0.9 |
| 13B | <13> | tert-BA | 23,000 | 1.5 | TPST | ◎ | 1.0 |
| 14B | <14> | tert-BA | 22,000 | 1.9 | TPST | ◎ | 1.2 |
| 15B | <15> | tert-BA | 21,000 | 1.8 | TPST | ◎ | 1.0 |
| 16B | <16> | tert-butoxy styrene/ tert-BA | 21,000 | 2.0 | TPST | ◎ | 1.5 |
| 17B | <17> | tert-butoxy styrene | 26,000 | 1.8 | TPST | ◎~○ | 1.8 |
| 18B | <18> | tert-BA/ tert-butoxy styrene | 24,000 | 1.7 | TPST | ◎~○ | 1.6 |
| 19B | <19> | tert-butoxy styrene | 23,000 | 1.8 | TPST | ◎~○ | 1.9 |
| 20B | <2> | tert-BA | 23,000 | 1.5 | BCSD | ◎~○ | 1.7 |
| 21B | <2> | tert-BA | 23,000 | 1.5 | BtBSD | ◎~○ | 1.6 |

Example 1C

Synthesis of Hyperbranched Polymer

In a 1000 mL reaction vessel, 630 mmol of chloromethyl styrene as a reactive monomer, and 315 mmol of 2,2-bipyridyl and 157.5 mmol of copper (I) chloride as a catalyst were placed together with 480 mL of chlorobenzene as a solvent. After the atmosphere in the reaction vessel was replaced with argon, a polymerization reaction was carried out with stirring at 125°C for 27 minutes. With the addition of 100 mL of tetrahydrofuran to the obtained reaction liquid, the resultant polymer was diluted and dissolved. After that, the reaction mixture was filtered through activated alumina to remove the catalyst. After the obtained filtrate was concentrated, the polymer was precipitated by the addition of 700 mL of methanol and the supernatant fluid was eliminated, thereby removing the unreacted monomers and the reaction solvent. Subsequently, the polymer dried under reduced pressure was washed with 600 mL of a mixed solvent of tetrahydrofuran and methanol (with a mixing ratio of 8:2 mL/mL) with stirring. The above-mentioned washing operation was repeated two times, thereby synthesizing a core portion G (in a 77% yield) having a weight average molecular weight (Mw) of 2,000 and a degree of branching of 0.47.

Then, 16.2 g of the above-mentioned core portion G as a starting polymer, 76 mmol of tert-butyl acrylate as an acid decomposition group-containing compound, and 53 mmol of 2,2-bipyridyl and 26 mmol of copper (I) chloride as a catalyst were placed in a 1000 mL reaction vessel together with 400 mL of chlorobenzene as a solvent. After the atmosphere in the reaction vessel was replaced with argon, a polymerization was carried out with stirring at 125°C for 5 hours. With the addition of 100 mL of tetrahydrofuran to the obtained reaction liquid, the resultant polymer was diluted and dissolved. After that, the reaction mixture was filtered through activated alumina to remove the catalyst. After the obtained filtrate was concentrated, the polymer was precipitated by the addition of 750 mL of methanol and the supernatant fluid was eliminated, thereby removing the unreacted monomers and the reaction solvent. Subsequently, the precipitated polymer was dissolved in 50 mL of tetrahydrofuran, and thereafter reprecipitated two times with the addition of 500 mL of methanol, thereby synthesizing a desired acid decomposition group-introduced hyperbranched polymer <20>.

Subsequently, 0.5 g of the hyperbranched polymer <20>, 0.75 mL of 10N hydrochloric acid, and 25 mL of dioxane were placed in a 50 mL reaction vessel. The mixture was heated and stirred at 85°C for 60 minutes to partially decompose the acid decomposition group. The resultant reaction liquid was poured into 250 mL of water to precipitate the polymer. Then, the supernatant fluid was eliminated and the precipitated polymer was dissolved in dioxane, and thereafter reprecipitated with water. This reprecipitating process was repeated, whereby a carboxyl group-introduced hyperbranched polymer <21> was synthesized, which is represented by the following formula:

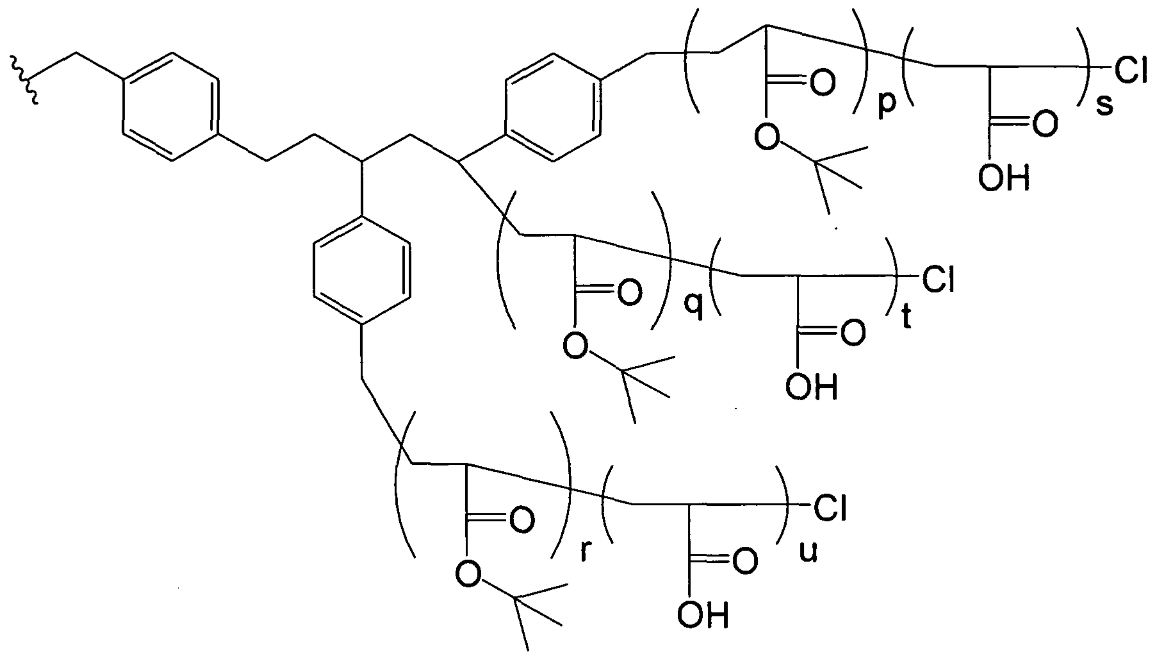

wherein p, q, r, s, t and u are each a number of 1 or more.

The weight average molecular weight of the obtained hyperbranched polymer <21> was obtained by the measurement of GPC mentioned above. The formulation for the obtained hyperbranched polymer was determined by measuring the $^1$H-NMR and calculating from the integral value for a proton characteristic of the acid decomposition group. The results are shown in Table 1C.

Removal of Copper Element from Polymer

A propylene glycol monomethyl acetate (PEGMEA) solution containing 7.5 mass% of the hyperbranched polymer <21> was prepared and then subjected to a treatment for removing the copper element using ion exchange membranes and a membrane film. Namely, 10 mL of the polymer solution was passed through a filtration filter at a flow rate of 4 mL/min under application of pressure for removal of metal, with the filtration filter being constructed in such a manner that three overlaid ion exchange membranes prepared by cutting "Protego CP" available from Nihon Mykrolis Corporation into a circle with a diameter of 47 mm were disposed over one membrane film with a pore size of 0.05 μm and a diameter of 47 mm, available from Millipore Corporation. After the removal treatment, the residual amount of copper element in the sample was quantitatively determined by MIP-MS (Hitachi, Ltd. P-6000, with a detection limit for copper being 50 ppb), using Constan's metallo-organic standards as a reference material. The results are shown in Table 1C.

Preparation of Resist Composition

A propylene glycol monomethyl acetate (PEGMEA) solution containing 4 mass% of the hyperbranched polymer <21> which had been subjected to the copper removal treatment and 0.04 mass% of triphenyl sulfonium trifluoromethanesulfonate as a photoacid generator was prepared and filtered through a filter with a pore size of 0.45 μm. Thus, a resist composition was prepared.

The obtained resist composition was spin-coated on a silicon wafer and subjected to a heat treatment of 90°C for one minute to evaporate the solvent so as to obtain a thin layer with a thickness of 100 nm was prepared.

Evaluation of Alkali Solubility

To obtain the alkali solubility, the sample thin layer with a thickness of about 100 nm formed on the silicon wafer was irradiated with UV light of a wavelength of 245 nm using an ultraviolet ray irradiation equipment of a discharge tube type (DNA-FIX DF-245, made by Atto Corporation) in such a fashion that UV rays with an energy intensity of 0 to 200 mJ/cm$^2$ were applied to a rectangle portion measuring 10 millimeters by 3 millimeters, and thereafter subjected to a heat treatment at 100°C for 4 minutes. Then, the sample was immersed in an aqueous solution containing 2.4 mass% of tetramethylammonium hydroxide (TMAH) as an alkaline chemical at 25°C for 2 minutes, and subsequently washed with water and dried. The thickness of the dried thin layer was measured using a thin-film thickness measurement instrument F-20 made by Filmetrics, Inc., and evaluated on the following criteria:

Non-exposed portion:

○: The layer thickness was decreased by 0 to less than 30%.
Δ: The layer thickness was decreased by 30 to less than 50%.
×: The layer thickness was decreased by 50 to 100%.

Light exposed portion:

○: The layer thickness was decreased by 100%.
Δ: The layer thickness was decreased by less than 100 to 90%.
×: The layer thickness was decreased by less than 90%.

Further, the minimum UV exposure (245 nm) capable of decreasing the layer thickness of the light exposed portion by 100% after immersing in an aqueous solution containing 2.4 mass% of tetramethylammonium hydroxide (TMAH) at 25°C for 2 minutes was determined as the sensitivity. The results are shown in Table 2C.

Measurement of Surface Roughness

The surface roughness of the light exposed surface was determined by the method described in Masao NAGASE, *Metrology of nano-structures using atomic force microscopy and its application to device and process for measurement,* Doctoral dissertation of Waseda University 2475, pp.99-107 (1996). Using an ultraviolet ray irradiation

equipment of a discharge tube type (DNA-FIX DF-245, made by Atto Corporation), the measurement of the surface roughness was conducted with respect to a surface irradiated with an exposure corresponding to 30% of the UV exposure (245 nm) by which the solubility in an alkaline aqueous solution was exhibited previously. The ultraviolet rays were applied to a rectangle portion measuring 10 millimeters by 3 millimeters on the sample thin layer with a thickness of about 500 nm formed on the silicon wafer, and then a heat treatment was conducted at 100°C for 4 minutes. Thereafter, the sample was immersed in an aqueous solution containing 2.4 mass% of tetramethylammonium hydroxide (TMAH) at 25°C for 2 minutes, and subsequently washed with water and dried. The dried surface was subjected to evaluation.
Using an atomic force microscopy (SPM-9500J3, made by Shimadzu Corporation), the surface roughness of the evaluation sample was determined by measuring a value of ten-point height of irregularities in accordance with JIS B0601-1994 as an index of surface roughness. The results are shown in Table 2C.

Example 2C

Synthesis of Hyperbranched Polymer

8.0 g of the hyperbranched polymer <20> described in Example 1C, 12.0 mL of 10N hydrochloric acid, and 400 mL of dioxane were placed in a 50 mL reaction vessel. The mixture was heated and stirred at 85°C for 65 minutes to partially decompose the acid decomposition group. After completion of the processes of purification and removal of copper element by the same method as in Example 1C, a carboxyl group-introduced hyperbranched polymer <22> was synthesized. The results are shown in Table 1C.

Preparation of Resist Composition

A resist composition was obtained in the same manner as in Example 1C except that the hyperbranched polymer <22> was employed, and then a sample for evaluation was prepared.
The alkali solubility, sensitivity, and surface roughness were evaluated in the same manner as in Example 1C. The results are shown in Table 2C.

Example 3C

Synthesis of Hyperbranched Polymer

In a 500 mL reaction vessel, 210 mmol of chloromethyl styrene as a reactive monomer, and 105 mmol of 2,2-bipyridyl and 52.5 mmol of copper (I) chloride as a catalyst were placed together with 160 mL of chlorobenzene as a solvent. After the atmosphere in the reaction vessel was replaced with argon, a polymerization reaction was carried out with stirring at 125°C for 40 minutes. With the addition of 100 mL of tetrahydrofuran to the obtained reaction liquid, the resultant polymer was diluted and dissolved. After that, the reaction mixture was filtered through activated alumina to remove the catalyst. After the obtained filtrate was concentrated, the polymer was precipitated by the addition of 200 mL of methanol and the supernatant fluid was eliminated, thereby removing the unreacted monomers and the reaction solvent. Subsequently, the polymer dried under reduced pressure was washed with 200 mL of a mixed solvent of tetrahydrofuran and methanol (with a mixing ratio of 7:3 mL/mL) with stirring. The above-mentioned washing operation was repeated two times, thereby synthesizing a core portion H (in a 70% yield) having a weight average molecular weight (Mw) of 4,000 and a degree of branching of 0.50.
Then, 13.1 g of the above-mentioned core portion H as a starting polymer, 62 mmol of tert-butyl acrylate as an acid decomposition group-containing compound, and 42.9 mmol of 2,2-bipyridyl and 21.5 mmol of copper (I) chloride as a catalyst were placed in a 1000 mL reaction vessel together with 327 mL of chlorobenzene as a solvent. After the atmosphere in the reaction vessel was replaced with argon, a polymerization was carried out with stirring at 125°C for 5 hours. The reaction product was subjected to purification in the same manner as in Example 1C, thereby synthesizing a desired acid decomposition group-introduced hyperbranched polymer <23>.
Subsequently, 0.5 g of the hyperbranched polymer <23>, 0.5 mL of 10N hydrochloric acid, and 25 mL of dioxane were placed in a 50 mL reaction vessel. The mixture was heated and stirred at 90°C for 60 minutes to partially decompose the acid decomposition group. After completion of the processes of purification and removal of copper element by the same method as in Example 1C, a carboxyl group-introduced hyperbranched polymer < 24> was synthesized. The results are shown in Table 1C.

Preparation of Resist Composition

A resist composition was obtained in the same manner as in Example 1C except that the hyperbranched

polymer <24> was employed, and then a sample for evaluation was prepared.

The alkali solubility, sensitivity, and surface roughness were evaluated in the same manner as in Example 1C. The results are shown in Table 2C.

Example 4C

Synthesis of Hyperbranched Polymer

12.0 g of the hyperbranched polymer <23> described in Example 3C, 24.0 mL of 10N hydrochloric acid, and 600 mL of dioxane were placed in a 50 mL reaction vessel. The mixture was heated and stirred at 90°C for 60 minutes to partially decompose the acid decomposition group. After completion of the processes of purification and removal of copper element by the same method as in Example 1C, a carboxyl group-introduced hyperbranched polymer <25> was synthesized. The results are shown in Table 1C.

Preparation of Resist Composition

A resist composition was obtained in the same manner as in Example 1C except that the hyperbranched polymer <25> was employed, and then a sample for evaluation was prepared.

The alkali solubility, sensitivity, and surface roughness were evaluated in the same manner as in Example 1C. The results are shown in Table 2C.

Example 5C

Synthesis of Hyperbranched Polymer

14.7 g of the above-mentioned core portion H as a starting polymer, 63 mmol of tert-butyl acrylate as an acid decomposition group-containing compound, and 24.1 mmol of 2,2-bipyridyl and 12.1 mmol of copper (I) chloride as a catalyst were placed in a 1000 mL reaction vessel together with 366 mL of chlorobenzene as a solvent. After the atmosphere in the reaction vessel was replaced with argon, a polymerization was carried out with stirring at 125°C for 3 hours. After completion of the process of purification by the same method as in Example 1C, a desired acid decomposition group-introduced hyperbranched polymer <26 > was synthesized.

Subsequently, 12.0 g of the hyperbranched polymer <26>, 54 mL of 10N hydrochloric acid, and 600 mL of dioxane were placed in a 1000 mL reaction vessel. The mixture was heated and stirred at 90°C for 60 minutes to partially decompose the acid decomposition group. After completion of the processes of purification and removal of copper element by the same method as in Example 1C, a carboxyl group-introduced hyperbranched polymer <27> was synthesized. The results are shown in Table 1C.

Preparation of Resist Composition

A resist composition was obtained in the same manner as in Example 1C except that the hyperbranched polymer <27> was employed, and then a sample for evaluation was prepared.

The alkali solubility, sensitivity, and surface roughness were evaluated in the same manner as in Example 1C. The results are shown in Table 2C.

Example 6C

Synthesis of Hyperbranched Polymer

0.6 g of the hyperbranched polymer <26> described in Example 5C, 2.4 mL of 10N hydrochloric acid, and 30 mL of dioxane were placed in a 50 mL reaction vessel. The mixture was heated and stirred at 90°C for 60 minutes to partially decompose the acid decomposition group. After completion of the processes of purification and removal of copper element by the same method as in Example 1C, a carboxyl group-introduced hyperbranched polymer <28> was synthesized. The results are shown in Table 1C.

Preparation of Resist Composition

A resist composition was obtained in the same manner as in Example 1C except that the hyperbranched polymer <28> was employed, and then a sample for evaluation was prepared.

The alkali solubility, sensitivity, and surface roughness were evaluated in the same manner as in Example 1C. The results are shown in Table 2C.

Example 7C

Synthesis of Hyperbranched Polymer

0.6 g of the hyperbranched polymer <26> described in Example 5C, 2.7 mL of 10N hydrochloric acid, and 30 mL of dioxane were placed in a 50 mL reaction vessel. The mixture was heated and stirred at 90°C for 60 minutes to partially decompose the acid decomposition group. After completion of the processes of purification and removal of copper element by the same method as in Example 1C, a carboxyl group-introduced hyperbranched polymer <29> was synthesized. The results are shown in Table 1C.

Preparation of Resist Composition

A resist composition was obtained in the same manner as in Example 1C except that the hyperbranched polymer <29> was employed, and then a sample for evaluation was prepared.
The alkali solubility, sensitivity, and surface roughness were evaluated in the same manner as in Example 1C. The results are shown in Table 2C.

Table 1C.

| Example | Hyperbranched Polymer | | | | | | | Weight Average Molecular Weight (Mw) | Residual Amount of Cu (ppb) |
|---|---|---|---|---|---|---|---|---|---|
| | No. | Core portion of molecule | Constituent units of acid decomposition group | | Molar ratio (%) with respect to constituent units of polymer | | | | |
| | | | 1 | 2 | Core | 1 | 2 | | |
| 1C | <21> | G | tert-BA | acrylic acid | 31 | 60.7 | 8.3 | 5,500 | 50 or less |
| 2C | <22> | G | tert-BA | acrylic acid | 31 | 55.9 | 13.1 | 5,400 | 50 or less |
| 3C | <24> | H | tert-BA | acrylic acid | 31 | 55.2 | 13.8 | 10,800 | 50 or less |
| 4C | <25> | H | tert-BA | acrylic acid | 31 | 51.1 | 17.9 | 10,600 | 50 or less |
| 5C | <27> | H | tert-BA | acrylic acid | 48 | 32.2 | 19.8 | 7,000 | 50 or less |
| 6C | <28> | H | tert-BA | acrylic acid | 48 | 26.5 | 25.5 | 6,800 | 50 or less |
| 7C | <29> | H | tert-BA | acrylic acid | 48 | 21.8 | 30.2 | 6,700 | 50 or less |

Table 2C

| Example | Components for Resist | | | Results of UV Exposure | | | |
|---|---|---|---|---|---|---|---|
| | Hyper branched polymer | Weight average molecular weight (Mw) | Photoacid generator | Solubility of non-exposed portion | Solubility of light exposed portion | Sensitivity ($mJ/cm^2$) | Surface roughness (nm) |
| 1C | <21> | 5,500 | TPST | ○ | ○ | 10 | 0.9 |
| 2C | <22> | 5,400 | TPST | ○ | ○ | 5 | 0.7 |

(continued)

| Example | Components for Resist | | | Results of UV Exposure | | | |
|---|---|---|---|---|---|---|---|
| | Hyper branched polymer | Weight average molecular weight (Mw) | Photoacid generator | Solubility of non-exposed portion | Solubility of light exposed portion | Sensitivity ($mJ/cm^2$) | Surface roughness (nm) |
| 3C | <24> | 10,800 | TPST | ○ | ○ | 10 | 1.5 |
| 4C | <25> | 10,600 | TPST | ○ | ○ | 10 | 1.4 |
| 5C | <27> | 7,000 | TPST | ○ | ○ | 80 | 1.2 |
| 6C | <28> | 6,800 | TPST | ○ | ○ | 20 | 1.2 |
| 7C | <29> | 6,700 | TPST | ○ | ○ | 5 | 1.1 |

It is apparent from the above-mentioned results that the resist compositions using the hyperbranched polymer of the present invention show excellent solubility and surface smoothness in the electron beam lithography or photolithography. In particular, as is apparent from the results of Examples 1B, 2B and 12B through 15B in Table 2B, the resists containing a polymer where tert-butyl acrylate is introduced at the introduction ratio of 1 or more can create vertical edges and extremely low surface roughness, are therefore those resists are found to be suitable for the formation of extremely fine patterns. Further, the results of Tables 1C and 2C, especially the results of Examples 2C and 7C demonstrate that the resist compositions which contain the hyperbranched polymer having as the acid decomposition groups tert-butyl acrylate and acrylic acid, with the element of copper derived from the polymerization catalyst being reduced to the order of ppb show extremely high sensitivities, which can sufficiently satisfy the level of sensitivity required of the lithography aimed at high throughput.

Industrial Applicability

The hyperbranched polymer of the present invention can be preferably used as a base resin for the resist material compatible with the light sources of electron beams, deep ultraviolet (DUV) and extreme ultraviolet (EUV) which are required to produce nano-order surface smoothness.

The resist composition of the present invention is capable of forming minute patterns thereon for fabrication of very large scale integrated circuits (VLSI), and is ready for the formation of extremely minute patterns of 50 nm or narrower which will be needed in future.

## Claims

1. A hyperbranched polymer having an acid decomposition group at the end of a molecule of the polymer.

2. Ahyperbranched polymer obtainable by subjecting a styrene derivative to a living radical polymerization, wherein the hyperbranched polymer has an acid decomposition group at the end of a molecule of the polymer.

3. The hyperbranched polymer of claim 1, which has a core portion which is a homopolymer of a monomer represented by formula (1):

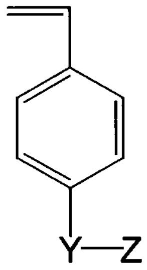

(1)

wherein Y is an alkylene group having 1 to 10 carbon atoms, which may include a hydroxyl group(s) or carboxyl group(s), and Z is a halogen atom; or
a copolymer of the monomer of formula (1) and at least one monomer selected from monomers of formulas (2) to (5):

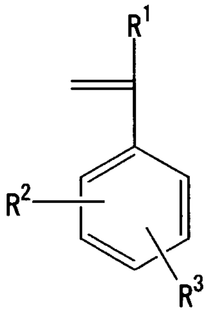

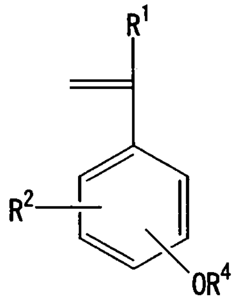

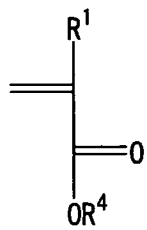

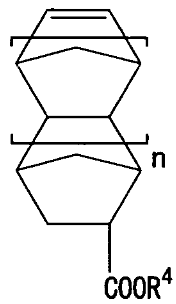

(2) (3) (4) (5)

wherein $R^1$ is hydrogen atom or an alkyl group having 1 to 3 carbon atoms; $R^2$ and $R^3$, which may be the same or different, are each hydrogen atom, a straight-chain, branched or cyclic alkyl group having 1 to 30 carbon atoms, or an aryl group having 6 to 30 carbon atoms; $R^4$ is hydrogen atom, a straight-chain, branched or cyclic alkyl group having 1 to 40 carbon atoms, a trialkylsilyl group in which each alkyl moiety has 1 to 6 carbon atoms, an oxoalkyl group in which an alkyl moiety has 4 to 20 carbon atoms, or a group represented by formula (6):

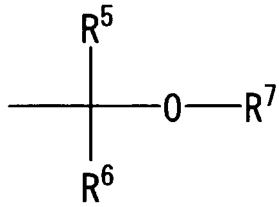

(6)

in which
$R^5$ is a straight-chain, branched or cyclic alkyl group having 1 to 10 carbon atoms; and $R^6$ and $R^7$ are each independently hydrogen atom or a straight-chain, branched or cyclic alkyl group having 1 to 10 carbon atoms, or $R^6$ and $R^7$ may form a ring together when $R^6$ and $R^7$ are each a straight-chain or branched alkyl group having 1 to 10 carbon atoms; and n is an integer from 0 to 10.

4. The hyperbranched polymer of any one of claims 1 to 3, wherein the acid decomposition group is at least one selected from the group consisting of groups represented by formulas (I) to (IV) and (7):

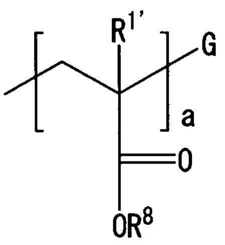
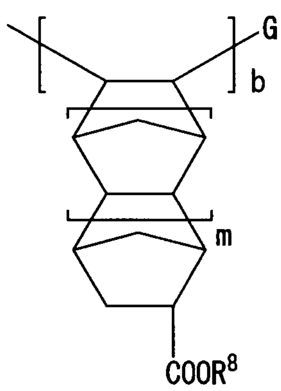
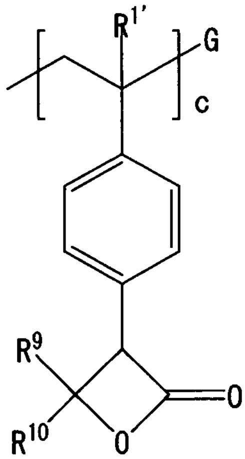
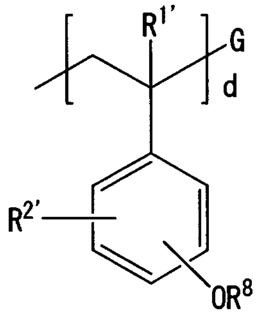

(I) (II) (III) (IV)

wherein $R^{1'}$ and $R^{2'}$ are the same as those defined in $R^1$ and $R^2$; $R^8$ is hydrogen atom, a straight-chain, branched or cyclic alkyl group having 3 to 40 carbon atoms, a trialkylsilyl group in which each alkyl moiety has 1 to 6 carbon atoms, an oxoalkyl group in which an alkyl moiety has 4 to 20 carbon atoms, or the group represented by formula (6); $R^9$ and $R^{10}$ are each hydrogen atom, a straight-chain, branched or cyclic alkyl group having 1 to 10 carbon atoms, or an aryl group having 6 to 30 carbon atoms, and $R^9$ and $R^{10}$ may be the same or different and may form a ring together; G represents a halogen atom, hydrogen atom, a straight-chain, branched or cyclic alkyl group having 1 to 10 carbon atoms, an aryl group having 6 to 30 carbon atoms, an alkylcarbonyloxy group in which an alkyl moiety has 1 to 10 carbon atoms, an alkyloxy group in which an alkyl moiety has 1 to 10 carbon atoms, phenyloxy group, thioether group, amino group or cyano group; m is an integer of 0 to 10; and a, b, c and d are each an integer of 1 or more;

$$-X-W \qquad (7)$$

wherein X is oxygen atom, sulfur atom, nitrogen atom, a straight-chain or branched alkylene group having 1 to 6 carbon atoms or interatomic bond; and W is hydrogen atom, a straight-chain, branched or cyclic alkyl group having 1 to 10 carbon atoms, phenyl group, an alkoxyphenyl group having 7 to 20 carbon atoms, an alkoxycarbonyl group having 2 to 10 carbon atoms, or a group represented by formula (8):

$$-R^{11}-COO-R^{8'} \qquad (8)$$

in which $R^{11}$ is a straight-chain, branched or cyclic alkylene group having 1 to 30 carbon atoms or an arylene group having 6 to 30 carbon atoms, and $R^{11}$ may contain an ether linkage or ester linkage; and $R^{8'}$ is the same as that defined in $R^8$.

5. The hyperbranched polymer of claim 3 or 4, which is comprised of the core portion which is the homopolymer of the monomer of formula (1) or the copolymer of the monomer of formula (1) and at least one selected from the group consisting of the monomers of formulas (2) to (5); and the acid decomposition group of formula (I), (II), (III) or (7).

6. The hyperbranched polymer of claim 3 or 4, which is comprised of the core portion which is the homopolymer of the monomer of formula (1) or the copolymer of the monomer of formula (1) and at least one selected from the group consisting of the monomers of formulas (2) to (4); and the acid decomposition group of formula (I), (III) or (IV).

7. The hyperbranched polymer of claim 3 or 4, which is comprised of the core portion which is the copolymer of the

monomer of formula (1) and at least one selected from the group consisting of the monomers of formula (2), (4) and (5); and the acid decomposition group of formula (IV).

**8.** The hyperbranched polymer of any one of claims 3 to 7, wherein the monomer of formula (1) has Y that represents an alkylene group having 1 to 8 carbon atoms.

**9.** The hyperbranched polymer of any one of claims 3 to 8, wherein the monomer of formula (1) is chloromethyl styrene.

**10.** The hyperbranched polymer of any one of claims 1 to 9, wherein the hyperbranched polymer has a weight average molecular weight (Mw) of 2,000 to 150,000.

**11.** The resist composition of claim 10, wherein the hyperbranched polymer has a weight average molecular weight of 500 to 150,000.

**12.** The hyperbranched polymer of any one of claims 4 to 11, wherein a molar ratio of monomer units constituting the core portion is 10 to 90 mol% with respect to monomer units constituting the hyperbranched polymer.

**13.** The hyperbranched polymer of any one of claims 4 to 11, wherein a molar ratio of repeat units of at least one selected from formulas (I) to (IV) for constituting the acid decomposition group is 10 to 90 mol% with respect to monomer units constituting the hyperbranched polymer.

**14.** The hyperbranched polymer of any one of claims 4 to 11, wherein a molar ratio of the group of formula (7) for constituting the acid decomposition group is 10 to 50 mol% with respect to monomer units constituting the hyperbranched polymer.

**15.** The hyperbranched polymer of any one of claims 4 to 11, wherein a molar ratio of repeat units of at least one selected from formulas (I) to (IV) for constituting the acid decomposition group in which $R^8$ represents a hydrogen atom is 0 to 70 mol% with respect to monomer units constituting the hyperbranched polymer.

**16.** The hyperbranched polymer of any one of claims 1 to 15, wherein the metal element content of the polymer is less than 100 ppb.

**17.** A method for producing a hyperbranched polymer, comprising the step of carrying out a living radical polymerization of a monomer of the formula (1) alone or together with at least one monomer selected from monomers of the formulas (2) to (5) to produce a polymer, and the step of introducing an acid decomposition group into the polymer by reacting the polymer with a compound containing the acid decomposition group.

**18.** A method for producing a hyperbranched polymer, comprising:

the step of synthesizing a hyperbranched polymer by a living radical polymerization reaction of a monomer of formula (1):

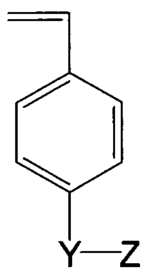

(1)

wherein Y is an alkylene group having 1 to 10 carbon atoms, which may include hydroxyl group or carboxyl group, and Z is a halogen atom; and
the step of introducing an acid decomposition group into the end of the hyperbranched polymer by reacting the synthesized hyperbranched polymer with a compound containing the acid decomposition group.

**19.** A resist composition comprising the hyperbranched polymer of any one of claims 1 to 16.

**20.** The resist composition of claim 19, further comprising a photoacid generator.

**INTERNATIONAL SEARCH REPORT**

International application No.
PCT/JP2004/019689

A. CLASSIFICATION OF SUBJECT MATTER
Int.Cl[7] C08F212/14, G03F7/039, H01L21/027

According to International Patent Classification (IPC) or to both national classification and IPC

B. FIELDS SEARCHED

Minimum documentation searched (classification system followed by classification symbols)
Int.Cl[7] C08F212/00-212/36, G03F7/039

Documentation searched other than minimum documentation to the extent that such documents are included in the fields searched

Electronic data base consulted during the international search (name of data base and, where practicable, search terms used)
WPI/L

C. DOCUMENTS CONSIDERED TO BE RELEVANT

| Category* | Citation of document, with indication, where appropriate, of the relevant passages | Relevant to claim No. |
|---|---|---|
| P,X | JP 2004-133393 A (Shin-Etsu Chemical Co., Ltd.), 30 April, 2004 (30.04.04), Claims; Par. Nos. [0054] to [0063] & US 2004/0033440 A1 | 1-20 |
| P,X | JP 2004-004614 A (Shin-Etsu Chemical Co., Ltd.), 08 January, 2004 (08.01.04), Claims; Par. Nos. [0074] to [0082] & US 2004/0215738 A1 | 1-20 |
| X | JP 2001-114825 A (Shin-Etsu Chemical Co., Ltd.), 24 April, 2001 (24.04.01), Claims; Par. Nos. [0030] to [0044] (Family: none) | 1-20 |

☒ Further documents are listed in the continuation of Box C.  ☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 16 March, 2005 (16.03.05) | 05 April, 2005 (05.04.05) |
| Name and mailing address of the ISA/ Japanese Patent Office | Authorized officer |
| Facsimile No. | Telephone No. |

Form PCT/ISA/210 (second sheet) (January 2004)

**INTERNATIONAL SEARCH REPORT**

International application No.
PCT/JP2004/019689

C (Continuation). DOCUMENTS CONSIDERED TO BE RELEVANT

| Category* | Citation of document, with indication, where appropriate, of the relevant passages | Relevant to claim No. |
|---|---|---|
| X | JP 2000-347412 A (Shin-Etsu Chemical Co., Ltd.), 15 December, 2000 (15.12.00), Claims; Par. Nos. [0059] to [0083] & EP 1039346 A1 & US 6455223 B1 | 1-20 |
| X | JP 2000-344836 A (Shin-Etsu Chemical Co., Ltd.), 12 December, 2000 (12.12.00), Claims; Par. Nos. [0058] to [0080] & EP 1038890 A1 & US 6414101 B1 | 1-20 |

Form PCT/ISA/210 (continuation of second sheet) (January 2004)

**INTERNATIONAL SEARCH REPORT**

International application No.
PCT/JP2004/019689

It appears that the expression "resist composition as claimed in claim 10" made in claim 11 is to read "hyperbranched polymer as claimed in claim 10".

Form PCT/ISA/210 (extra sheet) (January 2004)